# EUROPEAN PATENT APPLICATION

(11) **EP 4 589 385 A1**
(43) Date of publication of application: **23.07.2025**
(21) Application number: 23865488.3
(22) Date of filing: 11.09.2023
(51) Int. Cl.: G03F 7/26, H01L 21/027, H01L 21/3065

(54) **SUBSTRATE PROCESSING METHOD AND SUBSTRATE PROCESSING SYSTEM**

(30) Priority: 13.09.2022 JP 2022145646
(71) Applicant: Tokyo Electron Limited, Tokyo 107-6325 (JP)
(72) Inventor: KUMAKURA, Sho, Kurokawa-gun, Miyagi 981-3629 (JP); ONO, Kenta, Kurokawa-gun, Miyagi 981-3629 (JP); NAKANE, Yuta, Kurokawa-gun, Miyagi 981-3629 (JP); NISHIZUKA, Tetsuya, Kurokawa-gun, Miyagi 981-3629 (JP); HONDA, Masanobu, Kurokawa-gun, Miyagi 981-3629 (JP)
(74) Representative: FRKelly
(86) International application number: PCT/JP2023/033080
(87) International publication number: WO 2024/058135

(57) **Abstract**

To provide a technique of suppressing residues in a development pattern.

A substrate processing method is provided. This method includes providing a substrate on a substrate support in a chamber, the substrate having an underlying film and a metal-containing resist film formed on the underlying film, the metal-containing resist film having an exposed first region and an unexposed second region; and (b) supplying a processing gas to the chamber to develop the substrate and to selectively remove the second region from the metal-containing resist film, wherein the (b) includes (b1) controlling a temperature of the substrate or the substrate support to a first temperature to perform development, and (b2) controlling the temperature of the substrate or the substrate support to a second temperature different from the first temperature to perform development.

## Description

### Technical Field

An exemplary embodiment of the present disclosure relates to a substrate processing method and a substrate processing system.

### Background Art

Patent Literature 1 discloses a technique for forming a thin film that may be patterned using extreme ultraviolet light (hereinafter, referred to as "EUV light") on a semiconductor substrate.

### Citation List

### Patent Literature

Patent Literature 1: JP2021-523403A

### Summary of Invention

### Technical Problem

The present disclosure provides a technique for suppressing a residue of a development pattern.

### Solution to Problem

In one exemplary embodiment of the present disclosure, there is provided a substrate processing method including: (a) providing a substrate on a substrate support in a chamber, the substrate having an underlying film and a metal-containing resist film formed on the underlying film, the metal-containing resist film having an exposed first region and an unexposed second region; and (b) supplying a processing gas to the chamber to develop the substrate and to selectively remove the second region from the metal-containing resist film, in which the (b) includes (b1) controlling a temperature of the substrate support to a first temperature to perform development, and (b2) controlling the temperature of the substrate support to a second temperature different from the first temperature to perform development.

### Advantageous Effect of Invention

According to one exemplary embodiment of the present disclosure, it is possible to provide a technique for suppressing residues of a development pattern.

### Brief Description of Drawings

[Figure 1A] Figure 1A is a diagram for describing a configuration example of a heating processing system.
[Figure 1B] Figure 1B is a plan view illustrating another configuration example of a substrate support.
[Figure 2] Figure 2 is a diagram for describing a configuration example in a case where a plasma processing system is used as a development processing system.
[Figure 3] Figure 3 is a diagram for describing a configuration example of a capacitively coupled plasma processing apparatus.
[Figure 4] Figure 4 is a flowchart illustrating the present processing method.
[Figure 5] Figure 5 is a diagram illustrating an example of a cross-sectional structure of a substrate W provided in a step ST11.
[Figure 6] Figure 6 is a view illustrating an example of an underlying film UF of the substrate W.
[Figure 7] Figure 7 is a view illustrating an example of the underlying film UF of the substrate W.
[Figure 8] Figure 8 is a view illustrating an example of a cross-sectional structure of the substrate W after processing in a step ST12.
[Figure 9] Figure 9 is a diagram for describing an example of the step ST12.
[Figure 10] Figure 10 is a view schematically illustrating an example of a development occurring on a surface of the substrate W in the example illustrated in Figure 9.
[Figure 11] Figure 11 is a diagram for describing an example of the step ST12.
[Figure 12] Figure 12 is a diagram for describing an example of the step ST12.
[Figure 13] Figure 13 is a flowchart for a modification example of the present processing method.
[Figure 14] Figure 14 is a diagram for describing an example of the step ST12 in the modification example.
[Figure 15] Figure 15 is a diagram for describing an example of the step ST12 in the modification example.
[Figure 16] Figure 16 is a diagram illustrating results of development in Example 1 and Reference Example 1.
[Figure 17] Figure 17 is a block diagram for describing a configuration example of a substrate processing system SS.
[Figure 18] Figure 18 is a flowchart illustrating a method MT.

### Description of Embodiments

Hereinafter, each embodiment of the present disclosure will be described.

In one exemplary embodiment, there is provided a substrate processing method including: (a) providing a substrate on a substrate support in a chamber, the substrate having an underlying film and a metal-containing resist film formed on the underlying film, the metal-containing resist film having an exposed first region and an unexposed second region; and (b) supplying a processing gas to the chamber to develop the substrate and to selectively remove the second region from the metal-containing resist film, in which the (b) includes (b1) controlling a temperature of the substrate or the substrate support to a first temperature to perform development, and (b2) controlling the temperature of the substrate or the substrate support to a second temperature different from the first temperature to perform development.

In one exemplary embodiment, the second temperature is higher than the first temperature.

In one exemplary embodiment, in the (b2), the processing gas is not supplied to the chamber, or a flow rate of the processing gas supplied to the chamber is smaller than a flow rate of the processing gas supplied to the chamber in the (b1).

In one exemplary embodiment, a pressure in the chamber in the (b2) is lower than a pressure in the chamber in the (b1).

In one exemplary embodiment, the (b) further includes purging the processing gas in the chamber between the (b1) and the (b2).

In one exemplary embodiment, in the (b1) and the (b2), the processing gas is supplied to the chamber at a constant flow rate.

In one exemplary embodiment, there is provided a substrate processing method including: (a) providing a substrate on a substrate support in a chamber, the substrate having an underlying film and a metal-containing resist film formed on the underlying film, the metal-containing resist film having an exposed first region and an unexposed second region; and (b) supplying a processing gas to the chamber to develop the substrate and to selectively remove any one of the first region and the second region from the metal-containing resist film, in which the (b) includes (b1) performing development of the substrate under a first development condition, and (b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

In one exemplary embodiment, in the (b), the development is performed using plasma formed from the processing gas, and the development parameter further includes a level of power of a source RF signal for forming the plasma supplied to the chamber and a level of power or a voltage of a bias signal supplied to the chamber.

In one exemplary embodiment, the bias signal includes a bias RF signal or a voltage pulse, and the development parameter further includes at least one of a frequency of the source RF signal, a frequency of the bias RF signal, and a frequency of the voltage pulse.

In one exemplary embodiment, at least one of the source RF signal and the bias signal is pulsed, and the development parameter further includes at least one of a duty ratio of the pulsed source RF signal and a duty ratio of the pulsed bias signal.

In one exemplary embodiment, in the (b2), the second development condition is different from the first development condition in two or more of the development parameters.

In one exemplary embodiment, in the (b), the (b1) and the (b2) are repeated.

In one exemplary embodiment, in the (b), after a cycle including the (b1) and the (b2) is performed once or more, the (b1) is further performed.

In one exemplary embodiment, the (b) includes performing a cycle including the (b1) and the (b2) once or more by forming plasma from the processing gas after performing the cycle including the (b1) and the (b2) once or more without forming the plasma from the processing gas.

In one exemplary embodiment, the (b) includes performing a cycle including the (b1) and the (b2) once or more without forming plasma from the processing gas after performing the cycle including the (b1) and the (b2) once or more by forming the plasma from the processing gas.

In at least one of the (b1) and the (b2), the first region or the second region is selectively removed using plasma formed from the processing gas.

In one exemplary embodiment, the metal-containing resist film includes at least one metal selected from the group consisting of Sn, Hf, and Ti.

In one exemplary embodiment, the processing gas includes a halogen-containing gas.

In one exemplary embodiment, an acidity of a processing gas used in the (b1) is different from an acidity of a processing gas used in the (b2).

In one exemplary embodiment, the (c) is executed in a chamber different from the chamber used in the (b).

In one exemplary embodiment, the (c) is executed in the chamber used in the (b).

In one exemplary embodiment, the first region is exposed to EUV.

The temperature of the substrate or the substrate support is controlled by at least one selected from the group consisting of an output of a heater in the substrate support, an output of a heater in a side wall of the chamber accommodating the substrate support, an output of a heater in a ceiling of the chamber, a temperature of a heat transfer fluid flowing in the substrate support, a pressure of a heat transfer gas supplied between a back surface of the substrate and a front surface of the substrate support, and an output of electromagnetic waves configured to be emitted to a front surface of the substrate.

In an exemplary embodiment, there is provided a substrate processing system including: a substrate processing apparatus having a chamber; and a controller, in which the controller is configured to cause, with respect to the substrate processing apparatus, (a) providing a substrate on a substrate support in the chamber, the substrate having an underlying film and a metal-containing resist film formed on the underlying film, the metal-containing resist film having an exposed first region and an unexposed second region, and (b) supplying a processing gas to the chamber to develop the substrate and to selectively remove the second region from the metal-containing resist film, and the (b) includes (b1) performing development by controlling a temperature of the substrate or the substrate support to a first temperature, and (b2) performing development by controlling the temperature of the substrate or the substrate support to a second temperature different from the first temperature.

Hereinafter, each embodiment of the present disclosure will be described in detail with reference to the drawings. In each drawing, the same or similar elements will be given the same reference numerals, and repeated descriptions will be omitted. Unless otherwise specified, a positional relationship such as up, down, left, and right will be described based on a positional relationship illustrated in the drawings. A dimensional ratio in the drawings does not indicate an actual ratio, and the actual ratio is not limited to the ratio illustrated in the drawings.

### <Configuration Example of Heating Processing System>

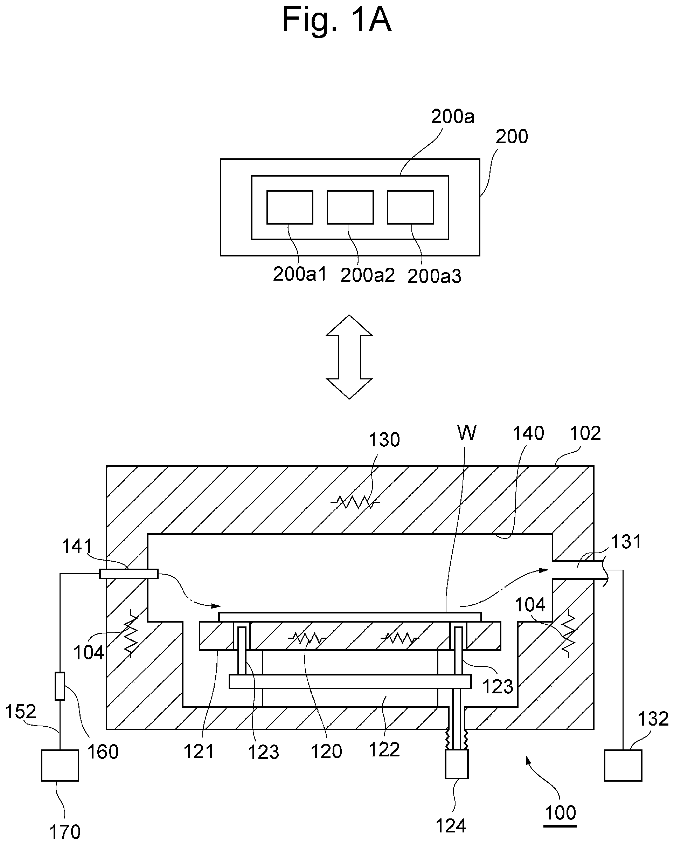

Figure 1A is a diagram for describing a configuration example of a heating processing system. In an embodiment, the heating processing system includes a heating processing apparatus 100 and a controller 200. The heating processing system is an example of a substrate processing system, and the heating processing apparatus 100 is an example of a substrate processing apparatus.

The heating processing apparatus 100 has a processing chamber 102 configured to form a sealed space. The processing chamber 102 is, for example, an airtight cylindrical container, and is configured to be able to adjust the atmosphere inside. A side wall heater 104 is provided on a side wall of the processing chamber 102. A ceiling heater 130 is provided on a ceiling wall (top plate) of the processing chamber 102. A ceiling surface 140 of the ceiling wall (top plate) of the processing chamber 102 is formed as a horizontal flat surface, and a temperature thereof is adjusted by the ceiling heater 130.

A substrate support 121 is provided on a lower side in the processing chamber 102. The substrate support 121 has a substrate support surface on which the substrate W is supported. The substrate support 121 is formed, for example, in a circular shape in a plan view, and the substrate W is placed on a surface (upper surface) thereof that is formed horizontally. A stage heater 120 is embedded in the substrate support 121. The stage heater 120 is able to heat the substrate W placed on the substrate support 121. A ring assembly (not illustrated) may be disposed on the substrate support 121 to surround the substrate W. The ring assembly may include one or a plurality of annular members. By disposing the ring assembly around the substrate W, it is possible to improve the temperature controllability of an outer peripheral region of the substrate W. The ring assembly may be made of an inorganic material or an organic material depending on desired heating processing.

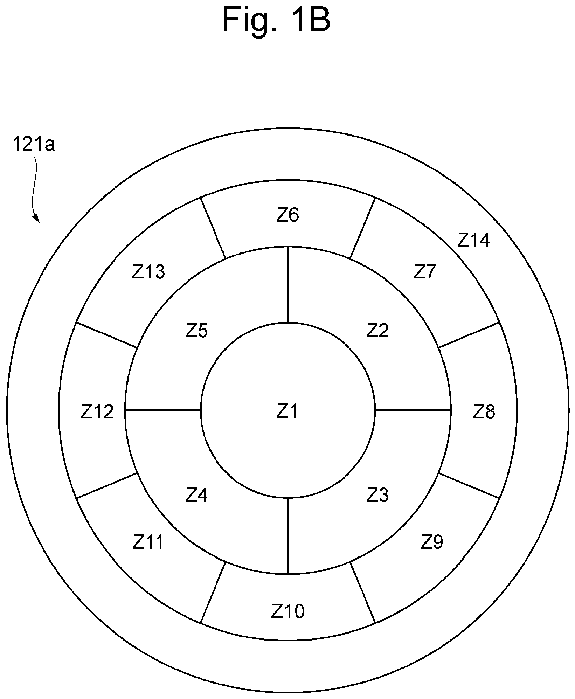

Figure 1B is a plan view illustrating another configuration example of the substrate support. In an embodiment, a substrate support 121a illustrated in Figure 1B may be used instead of the substrate support 121 illustrated in Figure 1A. The substrate support 121a illustrated in Figure 1B has a plurality of zones, and each zone includes a heater electrode. In the example illustrated in Figure 1B, the substrate support 121a has zones Z1 to Z14, and each zone has the heater electrode. The heater electrodes of the respective zones are configured such that power can be supplied independently. That is, the substrate support 121a is configured to be independently controllable in temperature for each zone. Therefore, according to the substrate support 121a, an in-plane uniformity in the development of the resist film RM, which will be described later, can be improved. In addition, according to the substrate support 121a, the substrate W can be sequentially heated from a center side to an edge side or can be sequentially heated from the edge side to the center side. Further, according to the substrate support 121a, a specific region of the substrate W can be heated to a higher temperature than other regions.

The substrate support 121 is supported in the processing chamber 102 by a support column 122 provided on a bottom surface of the processing chamber 102. A plurality of lifting and lowering pins 123 that is able to be vertically lifted or lowered is provided on an outside of the support column 122 in a circumferential direction. Each of the plurality of lifting and lowering pins 123 is inserted into each of through-holes provided in the substrate support 121. The plurality of lifting and lowering pins 123 is arranged at intervals in the circumferential direction. Lifting and lowering operations of the plurality of lifting and lowering pins 123 are controlled by a lifting and lowering mechanism 124. When the lifting and lowering pin 123 protrudes from the surface of the substrate support 121, the substrate W is able to be delivered between a transport mechanism (not illustrated) and the substrate support 121.

An exhaust port 131 having an opening is provided in a side wall of the processing chamber 102. The exhaust port 131 is connected to an exhaust mechanism 132 via an exhaust pipe. The exhaust mechanism 132 is configured of a vacuum pump, a valve, and the like, and adjusts an exhaust flow rate from the exhaust port 131. A pressure in the processing chamber 102 is adjusted by adjusting the exhaust flow rate and the like by the exhaust mechanism 132. A transport port (not illustrated) of the substrate W is formed on the side wall of the processing chamber 102 to be openable and closable at a position different from a position at which the exhaust port 131 is opened.

In addition, a gas nozzle 141 is provided on the side wall of the processing chamber 102 at a position different from the positions of the exhaust port 131 and the transport port of the substrate W. The gas nozzle 141 supplies a processing gas into the processing chamber 102. The gas nozzle 141 is provided on a side opposite to the exhaust port 131 as viewed from a center portion of the substrate support 121 in the side wall of the processing chamber 102. That is, the gas nozzle 141 is provided to be symmetrical with respect to the exhaust port 131 on a vertical imaginary plane passing through the center portion of the substrate support 121 in the side wall of the processing chamber 102.

The gas nozzle 141 is formed in a rod shape that protrudes from the side wall of the processing chamber 102 toward the center side of the processing chamber 102. A distal end portion of the gas nozzle 141 extends, for example, horizontally from the side wall of the processing chamber 102. The processing gas is discharged into the processing chamber 102 from a discharge port that is open at the distal end of the gas nozzle 141, flows in a direction of a one-dot chain line arrow illustrated in Figure 1A, and is exhausted from the exhaust port 131. The exhaust port 131 may be provided on the bottom surface of the processing chamber 102. In addition, the distal end portion of the gas nozzle 141 may have a shape that extends obliquely downward toward the substrate W, or may have a shape that extends obliquely upward toward the ceiling surface 140 of the processing chamber 102.

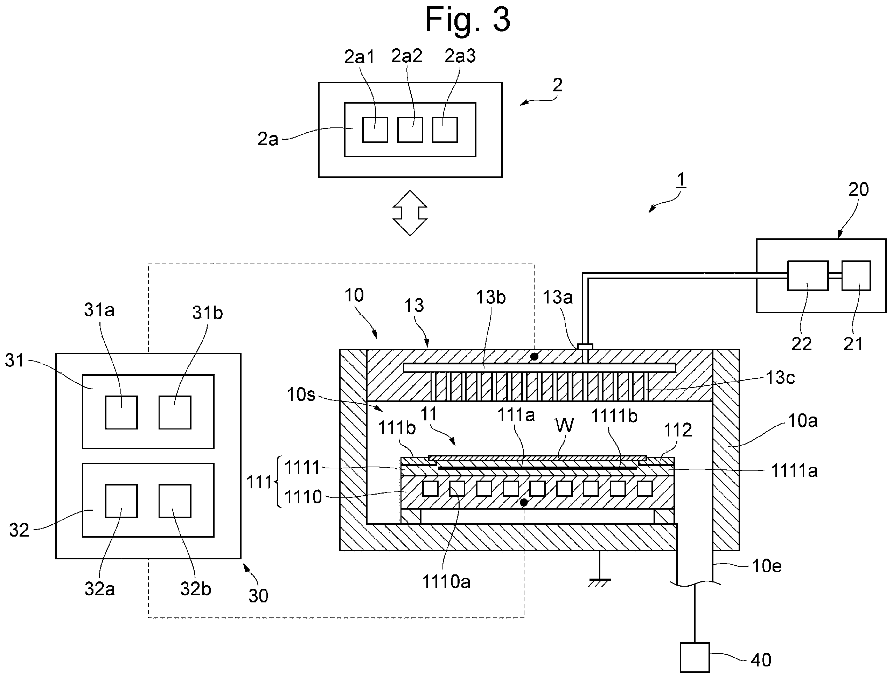

The gas nozzle 141 may be provided, for example, on the ceiling wall of the processing chamber 102. A plurality of gas nozzles 141 may be provided on the ceiling wall. In addition, instead of the gas nozzle, the same configuration as a shower head 13 illustrated in Figure 3 described later may be provided. The flow rate of the gas or the type of the gas supplied to the substrate W from the plurality of gas nozzles or shower heads may be configured to be controllable for each region (for example, the zones Z1 to Z14 in Figure 1B) of the substrate W. In an embodiment, the flow rate of the gas supplied to the central region of the substrate W may be higher than the flow rate of the gas supplied to the outer region of the substrate W.

The heating processing apparatus 100 includes a gas supply pipe 152 connected to the gas nozzle 141 from the outside of the processing chamber 102. A pipe heater 160 for heating the gas in the gas supply pipe is provided around the gas supply pipe 152. The gas supply pipe 152 is connected to a gas supply 170. The gas supply 170 includes at least one gas source and at least one flow rate controller. The gas supply may include a vaporizer that vaporizes a material in a liquid state.

The controller 200 processes a computer-executable instruction that causes the heating processing apparatus 100 to execute various steps described in the present disclosure. The controller 200 may be configured to control each element of the heating processing apparatus 100 to execute the various steps described here. In an embodiment, a part or all of the controller 200 may be included in the heating processing apparatus 100. The controller 200 may include a processor 200a1, a storage unit 200a2, and a communication interface 200a3. The controller 200 is realized by, for example, a computer 200a. The processor 200a1 may be configured to read out a program from the storage unit 200a2 and execute the read out program to perform various control operations. This program may be stored in the storage unit 200a2 in advance, or may be acquired through a medium when necessary. The acquired program is stored in the storage unit 200a2 and is read out from the storage unit 200a2 and executed by the processor 200a1. The medium may be various storage media readable by the computer 200a, or may be a communication line connected to the communication interface 200a3. The processor 200a1 may be a central processing unit (CPU). The storage unit 200a2 may include a random access memory (RAM), a read only memory (ROM), a hard disk drive (HDD), a solid state drive (SSD), or a combination thereof. The communication interface 200a3 may communicate with the heating processing apparatus 100 through a communication line such as a local area network (LAN).

### <Configuration Example of Plasma Processing System>

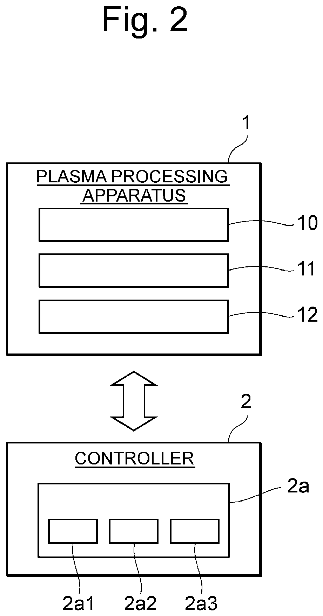

Figure 2 is a diagram for describing a configuration example in a case where a plasma processing system is used as a development processing system. In an embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas to the plasma processing space and at least one gas exhaust port for exhausting the gas from the plasma processing space. The gas supply port is connected to a gas supply 20, described later, and the gas exhaust port is connected to an exhaust system 40, described later. The substrate support 11 is disposed in the plasma processing space and has a substrate support surface for supporting a substrate.

The plasma generator 12 is configured to form a plasma from at least one processing gas supplied into the plasma processing space. The plasma formed in the plasma processing space may be a capacitively coupled plasma (CCP), an inductively coupled plasma (ICP), an electron-cyclotron-resonance plasma (ECR), a helicon wave plasma (HWP), a surface wave plasma (SWP), or the like. Further, various types of plasma generators including an alternating current (AC) plasma generator and a direct current (DC) plasma generator may be used. In an embodiment, an AC signal (AC power) used in the AC plasma generator has a frequency in the range of 100 kHz to 10 GHz. Therefore, the AC signal includes a radio frequency (RF) signal and a microwave signal. In an embodiment, an RF signal has a frequency in the range of 100 kHz to 150 MHz.

The controller 2 processes a computer-executable instruction that causes the plasma processing apparatus 1 to execute various steps described in the present disclosure. The controller 2 may be configured to control each element of the plasma processing apparatus 1 to execute the various steps described here. In an embodiment, a part or all of the controller 2 may be included in the plasma processing apparatus 1. The controller 2 is realized by, for example, a computer 2a. The controller 2 may include a processor 2a1, a storage unit 2a2, and a communication interface 2a3. Each configuration of the controller 2 may be the same as each configuration of the above-described controller 200 (see Figure 1A).

Hereinafter, a configuration example of the capacitively coupled plasma processing apparatus as an example of the plasma processing apparatus 1 will be described. Figure 3 is a diagram for describing the configuration example of the capacitively coupled plasma processing apparatus.

The capacitively coupled plasma processing apparatus 1 includes the plasma processing chamber 10, the gas supply 20, a power supply 30, and the exhaust system 40. In addition, the plasma processing apparatus 1 includes the substrate support 11 and a gas introducer. The gas introducer is configured to introduce at least one processing gas into the plasma processing chamber 10. The gas introducer includes the shower head 13. The substrate support 11 is disposed in the plasma processing chamber 10. The shower head 13 is disposed above the substrate support 11. In an embodiment, the shower head 13 configures at least a part of a ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a main body 111 and a ring assembly 112. The main body 111 has a center region 111a for supporting the substrate W and an annular region 111b for supporting the ring assembly 112. A wafer is an example of the substrate W. The annular region 111b of the main body 111 surrounds the center region 111a of the main body 111 in plan view. The substrate W is disposed on the center region 111a of the main body 111, and the ring assembly 112 is disposed on the annular region 111b of the main body 111 to surround the substrate W on the center region 111a of the main body 111. Therefore, the center region 111a is also referred to as a substrate support surface for supporting the substrate W, and the annular region 111b is also referred to as a ring support surface for supporting the ring assembly 112.

In an embodiment, the main body 111 includes a base 1110 and an electrostatic chuck 1111. The base 1110 includes a conductive member. The conductive member of the base 1110 may function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the center region 111a. In an embodiment, the ceramic member 1111a also has the annular region 111b. Another member that surrounds the electrostatic chuck 1111 may have the annular region 111b, such as an annular electrostatic chuck or an annular insulating member. In this case, the ring assembly 112 may be disposed on the annular electrostatic chuck or the annular insulating member, or may be disposed on both the electrostatic chuck 1111 and the annular insulating member. Further, at least one RF/DC electrode coupled to a RF power supply 31 and/or a DC power supply 32, which will be described later, may be disposed in the ceramic member 1111a. In this case, at least one RF/DC electrode functions as the lower electrode. When a bias RF signal and/or a DC signal, which will be described later, are supplied to at least one RF/DC electrode, the RF/DC electrode is also referred to as a bias electrode. The conductive member of the base 1110 and at least one RF/DC electrode may function as a plurality of lower electrodes. Further, the electrostatic electrode 1111b may function as the lower electrode. Therefore, the substrate support 11 includes at least one lower electrode.

The ring assembly 112 includes one or a plurality of annular members. In an embodiment, one or the plurality of annular members includes one or a plurality of edge rings and at least one cover ring. The edge ring is formed of a conductive material or an insulating material, and the cover ring is formed of an insulating material.

In addition, the substrate support 11 may include a temperature-controlled module configured to adjust at least one of the electrostatic chuck 1111, the ring assembly 112, and the substrate to a target temperature. The temperature-controlled module may include a heater, a heat transfer medium, a flow passage 1110a, or a combination thereof. A heat transfer fluid such as brine or a gas flows in the flow passage 1110a. In an embodiment, the flow passage 1110a is formed in the base 1110, and one or a plurality of heaters is disposed in the ceramic member 1111a of the electrostatic chuck 1111. Further, the substrate support 11 may include a heat transfer gas supply configured to supply the heat transfer gas to a gap between a back surface of the substrate W and the center region 111a. The substrate support 11 may have a plurality of zones and each zone may include a heater electrode, similarly to the substrate support 121a illustrated in Figure 1B. The heater electrodes of the respective zones may be configured to be capable of independently supplying power. That is, the substrate support 11 may be configured to be independently controllable in temperature for each zone.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. In addition to the shower head 13, the gas introducer may include one or a plurality of side gas injectors (SGI) attached to one or a plurality of opening portions formed on the side wall 10a.

The gas supply 20 may include at least one gas source 21 and at least one flow rate controller 22. In an embodiment, the gas supply 20 is configured to supply at least one processing gas to the shower head 13 from each corresponding gas source 21 through each corresponding flow rate controller 22. Each flow rate controller 22 may include, for example, a mass flow controller or a pressure-controlled flow rate controller. Further, the gas supply 20 may include at least one flow rate modulation device that modulates or pulses a flow rate of at least one processing gas.

The power supply 30 includes the RF power supply 31 coupled to the plasma processing chamber 10 via at least one impedance matching circuit. The RF power supply 31 is configured to supply at least one RF signal (RF power) to at least one lower electrode and/or at least one upper electrode. As a result, plasma is formed from at least one processing gas supplied to the plasma processing space 10s. Therefore, the RF power supply 31 may function as at least a part of the plasma generator 12. Further, by supplying the bias RF signal to at least one lower electrode, a bias potential is generated in the substrate W, and an ion component in the formed plasma is able to be drawn into the substrate W.

In an embodiment, the RF power supply 31 includes a first RF generator 31a and a second RF generator 31b. The first RF generator 31a is coupled to at least one lower electrode and/or at least one upper electrode via at least one impedance matching circuit and is configured to generate a source RF signal (source RF power) for plasma generation. In an embodiment, the source RF signal has a frequency in a range of 10 MHz to 150 MHz. In an embodiment, the first RF generator 31a may be configured to generate a plurality of source RF signals having different frequencies. The generated one or plurality of source RF signals is supplied to at least one lower electrode and/or at least one upper electrode.

The second RF generator 31b is coupled to at least one lower electrode via at least one impedance matching circuit and is configured to generate the bias RF signal (bias RF power). The frequency of the bias RF signal may be the same as or different from the frequency of the source RF signal. In an embodiment, the bias RF signal has a frequency lower than the frequency of the source RF signal. In an embodiment, the bias RF signal has a frequency in a range of 100 kHz to 60 MHz. In an embodiment, the second RF generator 31b may be configured to generate a plurality of bias RF signals having different frequencies. The generated one or plurality of bias RF signals is supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In an embodiment, the first DC generator 32a is connected to at least one lower electrode, and is configured to generate the first DC signal. The generated first DC signal is applied to at least one lower electrode. In an embodiment, the second DC generator 32b is connected to at least one upper electrode and is configured to generate a second DC signal. The generated second DC signal is applied to at least one upper electrode.

In various embodiments, the first and second DC signals may be pulsed. In this case, a sequence of voltage pulses is applied to at least one lower electrode and/or at least one upper electrode. The voltage pulse may have a pulse waveform having a rectangular shape, a trapezoidal shape, a triangular shape, or a combination thereof. In an embodiment, a waveform generator for generating the sequence of voltage pulses from the DC signal is connected between the first DC generator 32a and at least one lower electrode. Therefore, the first DC generator 32a and the waveform generator configure the voltage pulse generator. When the second DC generator 32b and the waveform generator configure the voltage pulse generator, the voltage pulse generator is connected to at least one upper electrode. The voltage pulse may have a positive polarity or a negative polarity. In addition, the sequence of voltage pulses may include one or a plurality of positive voltage pulses and one or a plurality of negative voltage pulses in one cycle. The first and second DC generators 32a and 32b may be provided in addition to the RF power supply 31, and the first DC generator 32a may be provided instead of the second RF generator 31b.

The exhaust system 40 may be connected to, for example, a gas exhaust port 10e provided at a bottom portion of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

### <Example of Substrate Processing Method>

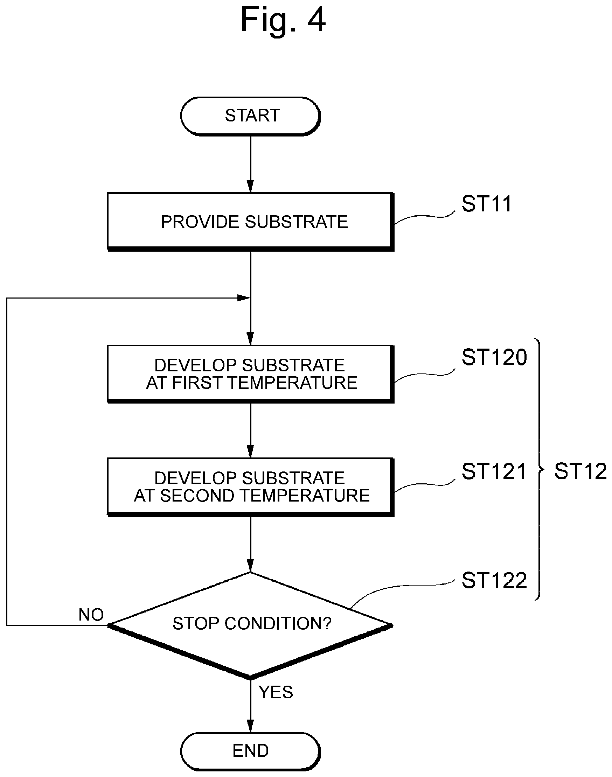

Figure 4 is a flowchart illustrating a substrate processing method (hereinafter, also referred to as "the present processing method") according to an exemplary embodiment. As illustrated in Figure 4, the present processing method includes a step ST11 of providing a substrate and a step ST12 of developing the substrate. The present processing method may be executed by the heating processing system (see Figure 1A) or the plasma processing system (see Figures 2 and 3). In the following, a case where the controller 200 controls each unit of the heating processing apparatus 100 to execute the present processing method on the substrate W will be described as an example.

### (Step ST11: Provision of Substrate)

First, in step ST11, the substrate W is provided in the processing chamber 102 of the heating processing apparatus 100. The substrate W is provided on the substrate support 121 via the lifting and lowering pin 123. After the substrate W is disposed on the substrate support 121, the temperature of the substrate W or the substrate support 121 is adjusted to a given set temperature. The temperature adjustment of the substrate W or the substrate support 121 may be performed by controlling an output of one or more heaters of the side wall heater 104, the stage heater 120, the ceiling heater 130, and the pipe heater 160 (hereinafter, also collectively referred to as "each heater"). In an example, the temperature of the substrate support 121 may be adjusted to the set temperature before the step ST11. That is, the substrate W may be provided on the substrate support 121 after the temperature of the substrate support 121 is adjusted to the set temperature.

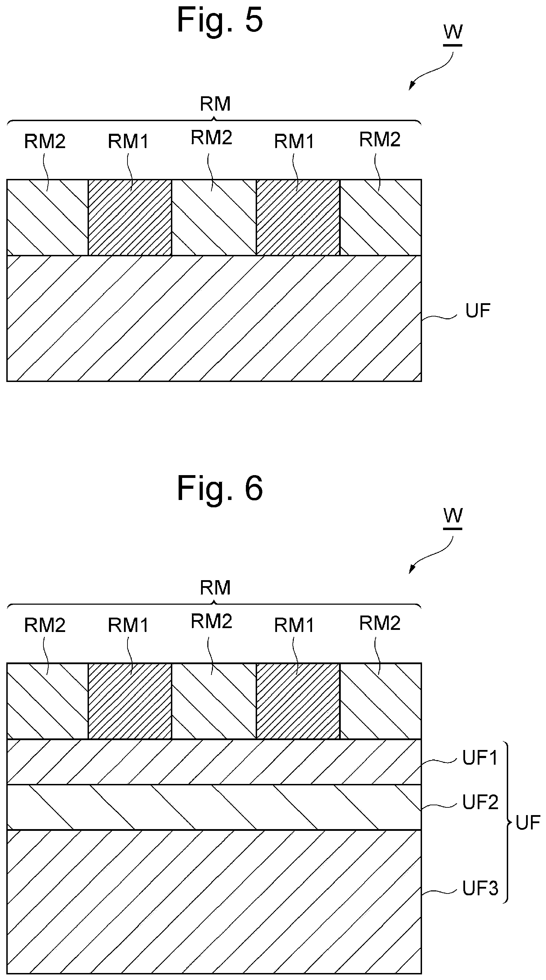

Figure 5 is a diagram illustrating an example of a cross-sectional structure of the substrate W provided in the step ST11. The substrate W includes an underlying film UF and a resist film RM formed on the underlying film UF. The substrate W may be used for manufacturing a semiconductor device. The semiconductor device includes, for example, a memory device such as a DRAM or a 3D-NAND flash memory, and a logic device.

As illustrated in Figure 5, the resist film RM has an exposed first region RM1 and an unexposed second region RM2. The first region RM1 is an EUV exposure region that is exposed to EUV. The second region RM2 is an unexposed region that is not exposed to EUV. A film thickness of the first region RM1 may be smaller than a film thickness of the second region RM2.

The resist film RM is a metal-containing resist film containing a metal. The metal may include at least one metal selected from the group consisting of Sn, Hf, and Ti, as an example. In an example, the resist film RM may contain Sn, and may contain tin oxide (SnO) and tin hydroxide (Sn-OH bond). The resist film RM may further contain an organic substance.

The underlying film UF may be an organic film, a dielectric film, a metal film, or a semiconductor film, or a film stack thereof formed on a silicon wafer. In an embodiment, the underlying film UF includes, for example, at least one selected from the group consisting of a silicon-containing film, a carbon-containing film, and a metal-containing film.

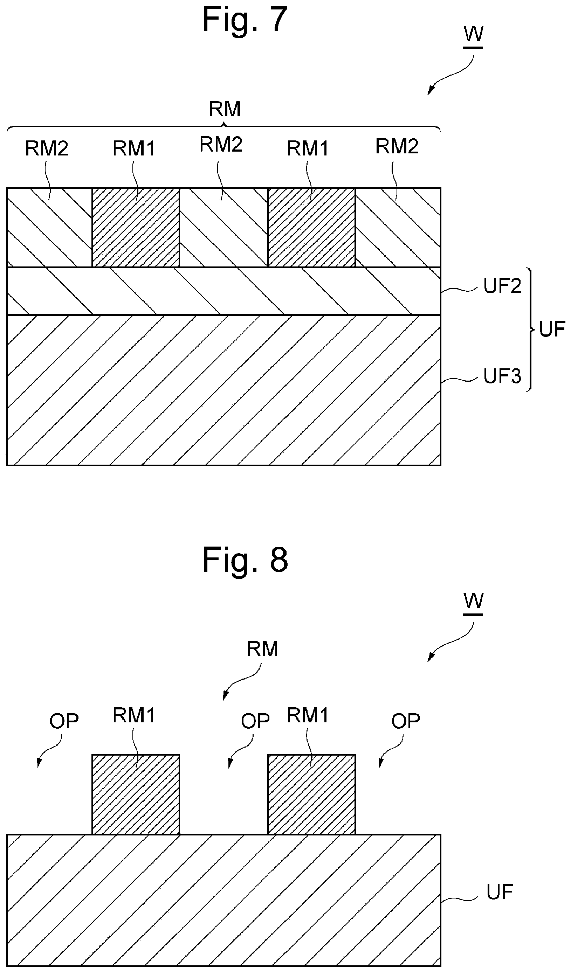

Figures 6 and 7 are views illustrating an example of the underlying film UF of the substrate W, respectively. As illustrated in Figure 6, the underlying film UF may be configured of a first film UF1, a second film UF2, and a third film UF3. As illustrated in Figure 7, the underlying film UF may be configured of the second film UF2 and the third film UF3.

The first film UF1 is, for example, a spin-on glass (SOG) film, a SiC film, a SiON film, a Si-containing antireflection film (SiARC), or an organic film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon acid nitride film, a silicon carbon nitride film, a polycrystalline silicon film, or a carbon-containing silicon film. The third film UF3 may be configured of a plurality of types of stacked silicon-containing films. For example, the third film UF3 may be configured of a silicon oxide film and a silicon nitride film which are alternately stacked. In addition, the third film UF3 may be configured of a silicon oxide film and a polycrystalline silicon film which are alternately stacked. In addition, the third film UF3 may be a film stack including a silicon nitride film, a silicon oxide film, and a polycrystalline silicon film. In addition, the third film UF3 may be configured of a stacked silicon oxide film and silicon carbon nitride film. In addition, the third film UF3 may be a film stack including a silicon oxide film, a silicon nitride film, and a silicon carbon nitride film.

In an embodiment, the substrate W is formed as follows. First, a photoresist film containing a metal is formed on an underlying film which is subjected to an adhesiveness processing or the like. The film formation may be carried out by a dry process, may be carried out by a wet process such as a solution coating method, or may be carried out by both the dry process and the wet process. Surface reforming processing of the underlying film may be included before the formation of the photoresist film. The substrate after the film formation of the photoresist film is subjected to a heating processing, that is, a post applied bake (PAB). The post applied baked substrate may be subjected to additional heating processing. The substrate after the heating processing is transported to an exposure apparatus, and the photoresist film is irradiated with EUV light through an exposure mask (reticle). As a result, the substrate W including the underlying film UF and the resist film RM having the exposed first region RM1 and the unexposed second region RM2 is formed. The first region RM1 is a region corresponding to an opening provided in the exposure mask (reticle). The second region RM2 is a region corresponding to a pattern provided on the exposure mask (reticle). The EUV has, for example, a wavelength in a range of 10 to 20 nm. The EUV may have a wavelength in a range of 11 to 14 nm, and has a wavelength of 13.5 nm in an example. The substrate after the exposure is transported from the exposure apparatus to the heating processing apparatus under atmosphere control, and is subjected to a heating processing, that is, a post-exposure bake (PEB). The substrate W after the PEB may be subjected to additional heating processing.

### (Step ST12: Development of Substrate)

Next, in Step ST12, the resist film RM of the substrate W is developed. In the present processing method, the second region RM2 may be selectively removed by development. In an embodiment, the step ST12 includes a step ST120 of developing the substrate at a first temperature, a step ST121 of developing the substrate at a second temperature different from the first temperature, and a step ST122 of determining whether a stop condition is satisfied.

### (Step ST120: Development of Substrate at First Temperature)

First, in Step ST120, the processing gas is supplied into the processing chamber 102 via the gas nozzle 141. In an embodiment, the processing gas includes a halogen-containing gas. The halogen-containing gas may be a gas containing a halogen-containing inorganic acid, and may be a gas of an inorganic acid containing Br or Cl. The gas containing a halogen-containing inorganic acid may be a gas containing a hydrogen halide and/or a boron halide. The gas including the halogen-containing inorganic acid is, for example, at least one selected from the group consisting of an HBr gas, a BCl₃ gas, an HCl gas, an HI gas, and an HF gas. In an embodiment, the processing gas may be a gas including an organic acid. The gas containing an organic acid may be, for example, a gas containing at least one selected from the group consisting of a carboxylic acid, a β-dicarbonyl compound, and an alcohol. In an embodiment, the processing gas is a gas including a carboxylic acid. The carboxylic acid may be, for example, formic acid (HCOOH), acetic acid (CH₃COOH), trichloroacetic acid (CCl₃COOH), monofluoroacetic acid (CFH₂COOH), difluoroacetic acid (CF2FCOOH), trifluoroacetic acid (CF₃COOH), chloro-difluoroacetic acid (CClF₂COOH), sulfur-containing acetic acid, thioacetic acid (CH₃COSH), thioglycolic acid (H SCH₂COOH), trifluoroacetic acid anhydride ((CF₃CO)₂O), or acetic acid anhydride ((CH₃CO)₂O). In an embodiment, the processing gas includes a β-dicarbonyl compound. The β-dicarbonyl compound may be, for example, acetylacetone (CH₃C(O)CH₂C(O)CH₃), trichloroacetylacetone (CCl₃C(O)CH₂C(O)CH₃), hexachloroacetylacetone (CCl₃C(O)CH₂C(O)CCl₃), trifluoroacetylacetone (CF₃C(O)CH₂C(O)CH₃), or hexafluoroacetylacetone (HFAc, CF₃C(O)CH₂C(O)CF₃). In an embodiment, the first processing gas includes an alcohol. The alcohol may be, for example, nonafluoro-tert-butyl alcohol ((CF₃)₃COH).

In an embodiment, the processing gas is a gas including trifluoroacetic acid. In an embodiment, the processing gas includes halogenated organic acid vapor. The processing gas includes, for example, at least one selected from the group consisting of trifluoroacetic acid anhydride, acetic acid anhydride, trichloroacetic acid, CFH₂COOH, CF₂HCOOH, chlorodifluoroacetic acid, sulfur-containing acetic acid, thioacetic acid, and thioglycolic acid. In an embodiment, the processing gas is a mixed gas of a carboxylic acid and a hydrogen halide or a mixed gas of acetic acid and formic acid. In an embodiment, the processing gas is a gas including acetic acid.

In the step ST120, the temperature of the substrate W or the substrate support 121 is controlled to the first temperature. The temperature of the substrate W or the substrate support 121 may be adjusted by controlling one or more outputs of each heater. The first temperature may be appropriately selected within a range in which the second region RM2 is removed from the first region RM1 with a sufficient selectivity. The first temperature may be appropriately selected according to the type of the processing gas. For example, in a case where HBr gas is used as the processing gas, the first temperature may be, for example, 10°C or higher and 30°C or lower, 10°C or higher and 20°C or lower, and is 10°C in one example. The step ST120 may be executed until a given period of time elapses or until the second region RM is removed to a given depth. The given period may be, for example, 0.1 seconds or more and 300 seconds or less, 0.1 seconds or more and 60 seconds or less, or 60 seconds or more and 300 seconds or less.

### (Step ST121: Development of Substrate at Second Temperature)

In the step ST121, the temperature of the substrate W or the substrate support 121 is controlled to the second temperature different from the first temperature. The temperature of the substrate W or the substrate support 11 may be adjusted by controlling one or more outputs of each heater. In an embodiment, the second temperature may be a temperature higher than the first temperature. The second temperature may be appropriately selected according to the type of the processing gas. For example, in a case where HBr gas is used as the processing gas, the temperature may be 40°C or higher and 100°C or lower and may be 50°C or higher and 100°C or lower, and is 60°C in one example.

In the step ST121, the processing gas may be supplied into the processing chamber 102 via the gas nozzle 141. In an embodiment, the flow rate of the processing gas is smaller than the flow rate of the processing gas in the step ST120. In the step ST121, the processing gas may not be supplied to the processing chamber 102.

In a case where the processing gas is supplied in the step ST121, the type of the processing gas may be the same as or different from the processing gas in the step ST120. In an embodiment, the acidity of the processing gas supplied in the step ST121 is lower than that in the step ST120. That is, in the step ST121, the processing gas having a larger acid dissociation constant (pKa) than the processing gas used in the step ST120 may be used. For example, the processing gas may be changed from HBr gas or BCl₃ (step ST120) to a carboxylic acid gas such as an acetic acid gas (step ST121). In addition, in the step ST121, the flow rate (partial pressure) of the processing gas having a large acid dissociation constant (pKa) may be increased with respect to the flow rate (partial pressure) of the processing gas used in the step ST120. For example, in a case where the processing gas in the step ST120 and the step ST121 is a mixed gas of HBr gas and carboxylic acid gas, the flow rate (partial pressure) of the carboxylic acid gas may be increased in the step ST121.

In the step ST121, the pressure in the processing chamber 102 may be the same as or different from the pressure in the step ST120. In an embodiment, the pressure in the processing chamber 102 in the step ST121 is lower than the pressure in the processing chamber 102 in the step ST120. For example, the pressure in the processing chamber 102 in step ST120 may be 50 mTorr or more and 500 mTorr or less, 50 mTorr or more and 400 mTorr or less, or 50 mTorr or more and 300 mTorr or less. For example, the pressure in the processing chamber 10 in the step ST121 may be set to 0.1 mTorr or more and 100 mTorr or less or 50 mTorr or more and 100 mTorr or less.

The step ST121 may be executed until a given period (for example, may be 0.1 seconds or more and 300 seconds or less, may be 0.1 seconds or more and 60 seconds or less, or may be 60 seconds or more and 300 seconds or less) elapses or the second region RM is removed to the given depth.

### (Step ST122: Determination)

In the step ST122, it is determined whether a given condition for ending the step ST12 is satisfied. In a case where it is determined that the given condition is not satisfied in the step ST122, the processing returns to the step ST120, and in a case where it is determined that the given condition is satisfied, the processing ends in the step ST12. The given condition may be, for example, that a cycle including the step ST120 and the step ST121 is repeatedly performed a preset number of times. The number of times may be once or a plurality of times. The given condition may be, for example, a condition related to the development time, that is, the time elapsed since the start of the step ST12. The given condition may be, for example, a condition related to a dimension such as a depth or an aspect ratio of an opening or a concave portion formed in the resist film RM after the step ST121. In this case, after the step ST121, it is determined whether the dimension of the resist film RM reaches a given value or range, and the cycle of the step ST120 and the step ST121 may be repeated until the dimension reaches the given value or range. The dimension of the resist film RM may be measured with an optical measuring apparatus.

In an embodiment, after the cycle including the step ST120 and the step ST121 is performed once or more, the determination of whether the given condition is satisfied may be executed after the step ST121 is ended in addition to the end of the step ST120. In a case where it is determined that the given condition is satisfied, the step ST12 may be ended without executing the step ST121.

In an embodiment, a step of purging the gas in the processing chamber 102 from the exhaust port 131 (hereinafter, also referred to as a "purge step") may be executed between the step ST120 and the step ST121. In this case, an inert gas or the like may be supplied into the processing chamber 102. As a result, gas of a reaction product generated by the development, excessive processing gas, and the like are purged.

Figure 8 is a view illustrating an example of a cross-sectional structure of the substrate W after processing in the step ST12. In the example illustrated in Figure 8, the second region RM2 of the resist film RM is removed, and the opening OP is formed. The opening OP is defined by a side surface of the first region RM1. The opening OP is a space on the underlying film UF surrounded by the side surface. The opening OP has a shape corresponding to the second region RM2 (a shape corresponding to the exposure mask pattern used for the EUV exposure as a result) in a plan view of the substrate W. The shape may be, for example, a circle, an ellipse, a rectangle, a line, or a shape in which one or more of these are combined. A plurality of openings OP may be formed in the resist film RM. The plurality of openings OP may each have a linear shape and may be arranged at regular intervals to form a line-and-space pattern. In addition, the plurality of the openings OP may be arranged in a lattice shape to form a pillar pattern.

According to the present processing method, the temperature of the substrate W or the substrate support 121 is changed in the step ST120 and the step ST121. In this manner, an amount of volatilization of the reaction product generated in the development can be adjusted. Therefore, a decrease in development speed or the generation of residues after development may be suppressed without volatilizing the reaction product.

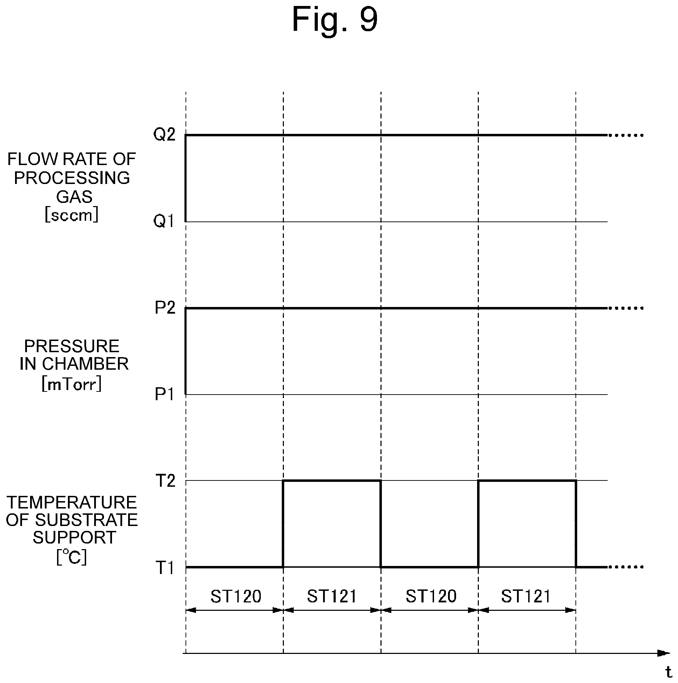

Figure 9 is a diagram for describing an example of the step ST12. In Figure 9, the horizontal axis indicates time. In addition, the vertical axis indicates a flow rate [sccm] of the processing gas supplied to the processing chamber 102, a pressure [Torr] in the processing chamber 102, and a temperature [°C] of the substrate support 121. "Q1" of the flow rate of the processing gas indicates that the processing gas is not supplied or the flow rate is smaller than the flow rate indicated by "Q2". The "P1" of the pressure in the processing chamber 102 indicates that the pressure is lower than "P2". The "T1" of the temperature of the substrate support 121 indicates that it is lower than the temperature of "T2". "T1" corresponds to the first temperature, and "T2" corresponds to the second temperature. Figure 9 is an example of a case where the temperature of the substrate support 121 is alternately changed between "T1" (step ST120) and "T2" (step ST121) while keeping the flow rate of the processing gas and the pressure in the processing chamber 102 constant in the step ST12.

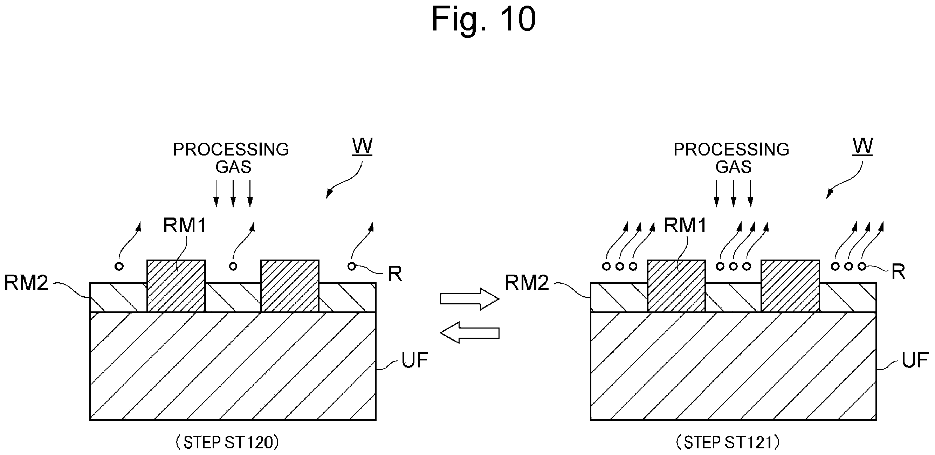

Figure 10 is a view schematically illustrating an example of the development occurring on the surface of the substrate W in the example illustrated in Figure 9. In the step ST120, the reaction product R generated by the reaction between the resist film of the second region RM2 and the processing gas is volatilized, and the second region RM2 is removed. When the development progresses and the concave portion formed in the resist film RM becomes deep, the reaction product R may be retained in the concave portion, the internal pressure may increase, and the volatilization of the reaction product R may be suppressed. In this regard, in the example illustrated in Figure 9, in the step ST121, the temperature of the substrate support 121 is set to a temperature higher than the temperature in the step ST120 (T2 > T1) to perform the development. Therefore, as illustrated in Figure 10, the volatilization of the reaction product R is promoted as compared with the step ST120. In this manner, it is possible to suppress the retention of the reaction product R in the concave portion and the decrease in the development speed.

In a case where development is continued at a high temperature, the development speed of the first region RM1 increases, and the first region RM1 may be removed together with the second region RM2. In this regard, in the example illustrated in Figure 9, since the development at the low temperature (T1) in the step ST120 and the development at the high temperature (T2) in the step ST121 are alternately repeated, the development at the high temperature (T2) is avoided from continuing. As a result, it is possible to suppress the excessive removal of the first region RM1 and the reduction in film thickness. That is, the selectivity of development (the ratio of the development speed of the second region RM2 to the development speed of the first region RM1, and also referred to as the contrast of the development) is improved.

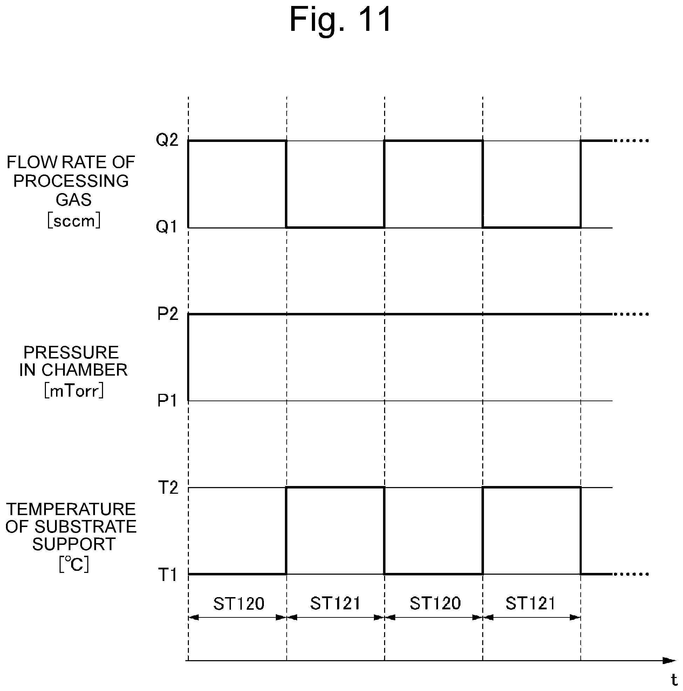

Figure 11 is a diagram for describing an example of the step ST12. The vertical axis and the horizontal axis in Figure 11 are the same as the vertical axis and the horizontal axis in Figure 9. The example illustrated in Figure 11 is different from the example illustrated in Figure 9 in that the processing gas is not supplied in the step ST121 or the processing gas is supplied at a flow rate smaller than that in the step ST120.

In the example illustrated in Figure 11, as in the example illustrated in Figure 9, in the step ST121, the temperature of the substrate support 121 is set to a temperature higher than the temperature in the step ST120 (T2 > T1) to perform the development. Therefore, the volatilization of the reaction product R is promoted as compared with the step ST120. As a result, it is possible to suppress the retention of the reaction product R in the concave portion and the decrease in the development speed. In addition, in the example illustrated in Figure 11, as in the example illustrated in Figure 9, since the development at the low temperature (T1) in the step ST120 and the development at the high temperature (T2) in the step ST121 are alternately repeated, the development at the high temperature (T2) is avoided from continuing. In addition, in the example illustrated in Figure 11, in the development at the high temperature (T2) in the step ST121, the supply amount of the processing gas is reduced or becomes zero as compared with the step ST120. As a result, an increase in the development speed of the first region RM1 due to an increase in the temperature of the substrate support 121 may be relaxed. As a result, it is possible to suppress the excessive removal of the first region RM1 and the reduction in film thickness. That is, the selectivity of development (the ratio of the development speed of the second region RM2 to the development speed of the first region RM1, and also referred to as the contrast of the development) is improved.

In the example illustrated in Figure 11, the timings of the increase (decrease) in the flow rate of the processing gas and the decrease (increase) in the temperature of the substrate support match each other, but the timings may be all or partially different from each other (the phases may be shifted from each other). That is, in the step ST121, at least a part of a period in which the flow rate of the processing gas is Q1 and a period in which the temperature of the substrate support is T2 may overlap each other.

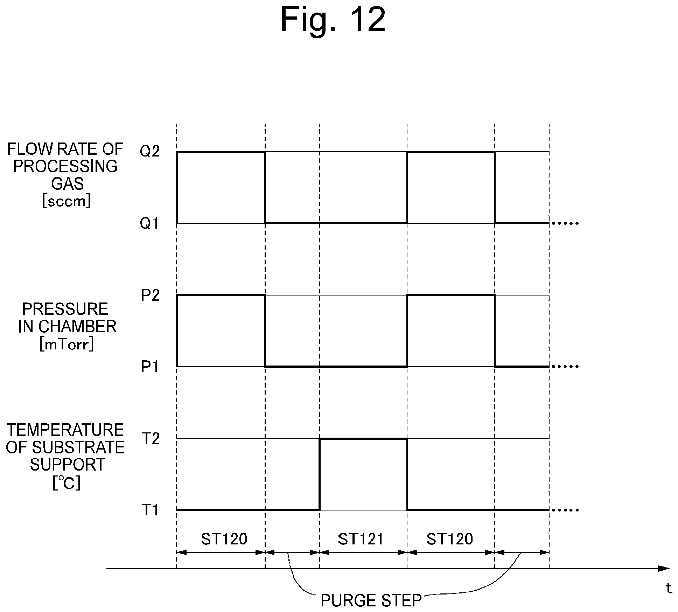

Figure 12 is a diagram for describing an example of the step ST12. The vertical axis and the horizontal axis in Figure 12 are the same as those in Figure 9. The example illustrated in Figure 12 is different from the example illustrated in Figure 11 in that the purge step is included between the step ST120 and the step ST121, and in that the pressure (P1) in the processing chamber 102 in the step ST121 is smaller than the pressure (P2) in the step ST120.

In the example illustrated in Figure 12, as in the example illustrated in Figure 9, in the step ST121, the development is performed at a temperature of the substrate support 121 higher than the temperature in the step ST120 (T2 > T1). Therefore, the volatilization of the reaction product R is promoted as compared with the step ST120. In addition, in the example illustrated in Figure 12, the purge step is performed between the step ST120 and the step ST121. As a result, it is possible to suppress the retention of the reaction product R in the concave portion and the decrease in the development speed. In addition, in the example illustrated in Figure 12, as in the example illustrated in Figure 9, since the development at the low temperature (T1) in the step ST120 and the development at the high temperature (T2) in the step ST121 are alternately repeated, the development at the high temperature (T2) is avoided from continuing. Furthermore, in the example illustrated in Figure 12, in the development at the high temperature (T2) in the step ST121, the supply amount of the processing gas is reduced as compared with the step ST120 or becomes zero, and the pressure in the processing chamber 102 is reduced as compared with the step ST120. As a result, an increase in the development speed of the first region RM1 due to an increase in the temperature of the substrate support 121 may be relaxed. As a result, it is possible to suppress the excessive removal of the first region RM1 and the reduction in film thickness. In the example illustrated in Figure 12, the timings of the increase in the flow rate of the processing gas, the increase in the pressure in the chamber, and the decrease in the temperature of the substrate support match each other, but the timings may be all or partially different from each other (the phases may be shifted from each other). That is, in the step ST121, at least a part of the period in which the flow rate of the processing gas is Q1 and the period in which the temperature of the substrate support is T2 may overlap each other.

In an embodiment, the present processing method may be executed using the plasma processing system (see Figures 2 and 3). For example, the resist film RM may be developed by providing the substrate W on the substrate support 11 in the processing chamber 10 of the plasma processing apparatus 1 (step ST11) and adjusting the temperature of the substrate W or the substrate support 11 by the temperature-controlled module (step ST12). The temperature of the substrate W or the substrate support 11 may be adjusted by controlling the pressure of the heat transfer gas (for example, He) between the electrostatic chuck 1111 and the back surface of the substrate W. The processing gas used in the step ST12 may be the same as that in a case where the heating processing system is used. In the step ST120 and/or the step ST121, the development may be executed by forming the plasma from the processing gas. That is, the source RF signal may be supplied to the lower electrode of the substrate support 11 and/or the upper electrode of the shower head 13. In this case, the bias signal may be supplied to the lower electrode of the substrate support 11.

In an embodiment, the development processing in the step ST12 may be performed by both the heating processing and the plasma processing. For example, after the cycle (hereinafter, also referred to as a "heating processing cycle") in which the step ST120 and the step ST121 are performed by the heating processing is executed once or more, the cycle (hereinafter, also referred to as a "plasma processing cycle") in which the step ST120 and the step ST121 are performed by the plasma processing may be executed once or more. In addition, for example, after the plasma processing cycle is executed once or more, the heating processing cycle may be executed once or more. In addition, for example, the heating processing cycle and the plasma processing cycle may be alternately executed a plurality of times. In addition, for example, the step ST120 may be performed by the heating processing, and the step ST121 may be performed by the plasma processing, or the step ST120 may be performed by the plasma processing, and the step ST121 may be performed by the heating processing.

In an embodiment, in the step ST12, instead of adjusting the temperature of the substrate support (the substrate support 121 or the substrate support 11), the substrate W may be directly heated to make the temperature of the substrate W in the step ST121 different from the temperature of the substrate W in the step ST120. For example, an apparatus that generates electromagnetic waves such as infrared light or microwaves may be provided in the heating processing apparatus 100 or the plasma processing apparatus 1, and the substrate W may be irradiated with the electromagnetic waves by the apparatus to adjust the temperature of the substrate W.

In an embodiment, the present processing method may include a desorption step. The desorption step includes removing (descumming) a scum from the surface of the resist film RM and the surface of the underlying film UF or smoothing the surface of the resist film RM with an inert gas or plasma of the inert gas. The desorption step may be executed after the step ST12. The desorption step may be repeatedly executed once or multiple times between the development and the development in the step ST12. The desorption step may be performed, for example, by exposing the substrate W to the plasma formed in the plasma processing apparatus 1. The desorption step may be performed, for example, by introducing the processing gas excited by a remote plasma source into the processing chamber 102 of the heating processing apparatus 100. The inert gas is noble gas such as He, Ar, Ne, Kr, and Xe, or nitrogen gas, for example.

In an embodiment, the present processing method may include a step of etching the underlying film UF after the step ST12. The etching may be performed, for example, by forming the plasma from the processing gas in the processing chamber 10 of the plasma processing apparatus 1. In the etching, the resist film RM functions as a mask, and a concave portion is formed in the underlying film UF based on the shape of the opening OP. In a case where the development is performed using the plasma processing apparatus 1 in the step ST12, the etching processing may be continuously executed in the same processing chamber 10 as in the step ST12, or may be executed in the processing chamber 10 of another plasma processing apparatus 1.

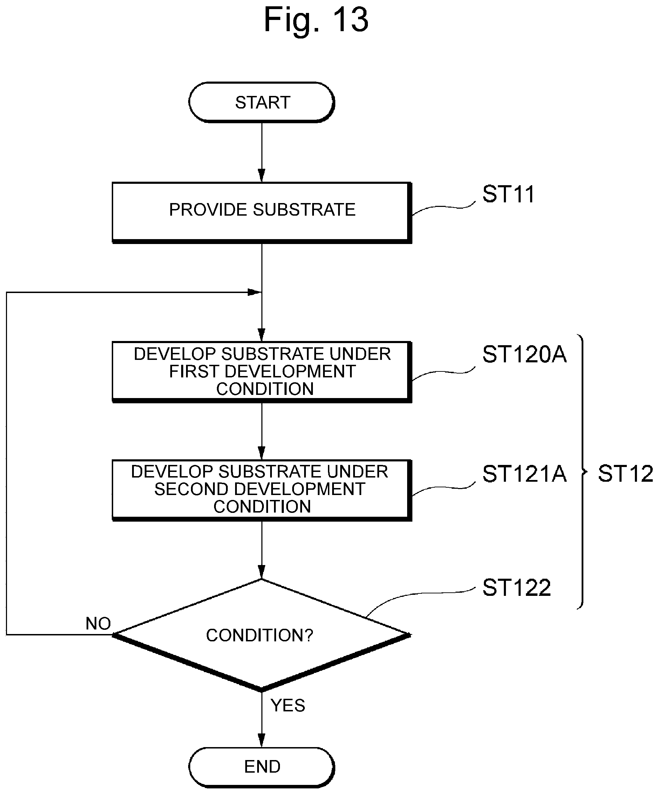

Figure 13 is a flowchart for a modification example of the present processing method. As illustrated in Figure 13, the step ST12 may include a step ST120A of developing the substrate under the first development condition and a step ST121A of developing the substrate under the second development condition instead of the above-described step ST120 and step ST121. The present modification example may be executed by the heating processing system (see Figure 1A) or the plasma processing system (see Figures 2 and 3).

The second development condition is different from the first development condition in at least one development parameter. In an embodiment, in the second development condition, two or more development parameters are different. The development parameter may include the temperatures of the substrate supports (121, 11), the temperature of the substrate W, the pressures in the processing chambers (102, 10), the flow rate of the processing gas, the type of the processing gas, and the residence time. The residence time is a retention time of the processing gas on the substrate W. The residence time is represented by (P × V)/Q in a case where the volume of the processing chamber is V, the pressure in the processing chamber is P, and the flow rate of the processing gas is Q. In a case where the present processing method is executed using the plasma processing system (see Figures 2 and 3), the development parameter may further include a level of power of the source RF signal for forming the plasma supplied to the processing chamber 10 and a level of power or voltage of the bias signal supplied to the processing chamber 10. The development parameter may further include a frequency of the source RF signal. In a case where the source RF signal is pulsed, the development parameter may further include a duty ratio of the pulsed source RF signal. In a case where the bias signal is the bias RF signal, the development parameter may further include the frequency of the bias RF signal. In a case where the bias RF signal is pulsed, the development signal may further include a duty ratio of the pulsed bias RF signal. In a case where the bias signal includes a voltage pulse, the development parameter may further include a frequency (pulse frequency) or a duty ratio of the voltage pulse.

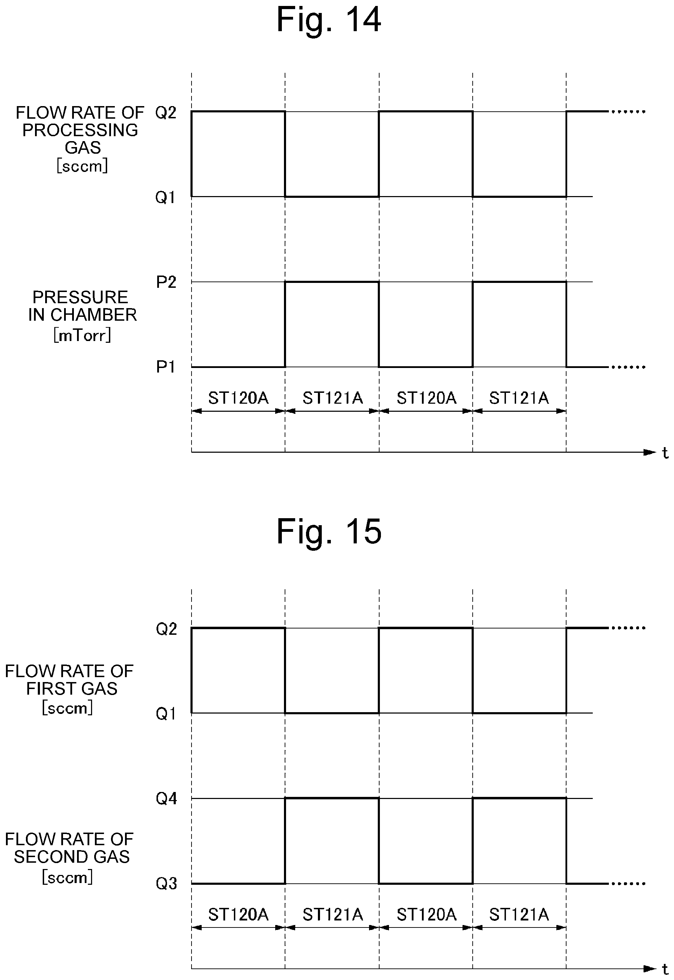

Figure 14 is a view for describing an example of the step ST12 in the modification example. In Figure 14, the horizontal axis indicates time. In addition, the vertical axis indicates the flow rate [sccm] of the processing gas supplied to the processing chambers (102, 10) and the pressure [mTorr] in the processing chambers (102, 10). "Q1" of the flow rate of the processing gas indicates that the processing gas is not supplied or the flow rate is smaller than the flow rate indicated by "Q2". The "P1" of the pressure in the processing chamber 102 indicates that the pressure is lower than "P2". Figure 14 is an example of a case where two of the flow rate of the processing gas and the pressure in the processing chamber are different among the development parameters of the first development condition and the second development condition. The other development parameters may be the same between the development condition 1 and the development condition 2. In addition, in the example illustrated in Figure 14, the timings of the increase (decrease) in the flow rate of the processing gas and the decrease (increase) in the pressure in the chamber match each other, but the timings may be all or partially different from each other (the phases may be shifted from each other). That is, in the step ST121A, at least a part of the period in which the flow rate of the processing gas is Q1 and the period in which the pressure in the chamber is P2 may overlap each other.

Figure 15 is a diagram for describing an example of the step ST12 in the modification example. In Figure 15, the horizontal axis indicates time. In addition, the vertical axis indicates the flow rates [sccm] of the first gas G1 and the second gas G2 included in the processing gas supplied to the processing chambers (102, 10). "Q1" of the flow rate of the first gas indicates that the flow rate of the first gas included in the processing gas is zero or smaller than the flow rate indicated by "Q2". "Q3" of the flow rate of the second gas indicates that the flow rate of the second gas included in the processing gas is zero or smaller than the flow rate indicated by "Q4". Figure 15 is an example of a case where the types of the processing gases are different from each other among the development parameters of the first development condition and the second development condition. In an embodiment, a gas having a larger acid dissociation constant (pKa) than the first gas is used as the second gas. In this case, the acidity of the processing gas used in the step ST121A is lower than the acidity of the processing gas used in the step ST120A. The other development parameters may be the same between the development condition 1 and the development condition 2. In addition, in the example illustrated in Figure 15, the timings of the increase (decrease) in the flow rate of the first processing gas and the decrease (increase) in the second processing gas match each other, but the timings may be all or partially different from each other (the phases may be shifted from each other). That is, in the step ST121, at least a part of the period in which the flow rate of the first gas is Q1 and the period in which the flow rate of the second gas is Q4 may overlap each other.

In the above-described exemplary embodiment, in the development in the step ST12, the second region RM2 of the resist film RM is selectively removed with respect to the first region RM1. However, the present processing method is not limited thereto. In an embodiment, in the development in the step ST12, the first region RM1 of the resist film RM may be selectively removed with respect to the second region RM2.

### <Examples>

Next, examples of the present processing method will be described. The present disclosure is not limited in any way by following examples.

### (Example 1)

In Example 1, the resist film RM was developed by applying the present processing method (see Figure 4) to the substrate W (see Figure 5) using the plasma processing apparatus 1 (see Figure 3).

In the step ST11, the substrate W was provided on the substrate support 11 in the processing chamber 10. The resist film RM of the substrate W was an organic film containing Sn, and had the first region RM1 that was exposed to EUV and the second region RM2 that was not exposed to EUV. The underlying film UF of the substrate W was the silicon oxide film. The film thickness of the second region RM2 was about 1.3 times larger than the film thickness of the first region RM1.

In the step ST12, the step ST120, the purge step, and the step ST122 were included. In the step ST12, the source RF signal and the bias signal were not supplied. That is, in the step ST12, the plasma was not formed from the processing gas.

The step ST120 was executed for 60 seconds. In the step ST120, the substrate support 11 was adjusted to 10°C. The processing gas contained HBr gas and Ar gas. The pressure in the processing chamber 10 was maintained at 200 mTorr.

The purge step was executed for 30 seconds. Ar gas was used for purge. The pressure in the processing chamber 10 was maintained at 10 mTorr or less.

Step ST121 was executed for 60 seconds. In the step ST121, the substrate support 11 was adjusted to 60°C. The processing gas contained Ar gas. The pressure in the processing chamber 10 was maintained at 10 mTorr or less.

### (Reference Example 1)

In Reference Example 1, the resist film RM of the substrate W (see Figure 5) was developed using the plasma processing apparatus 1 (see Figure 3). The development was continuously executed under the same conditions as in the step ST120 of Example 1 (the temperature of the substrate support 11 is 10°C, the pressure of the processing chamber 10 is 200 mTorr, and the processing gas includes the HBr gas and the Ar gas). That is, in Reference Example 1, unlike Example 1, the purge step and the step ST121 were not executed.

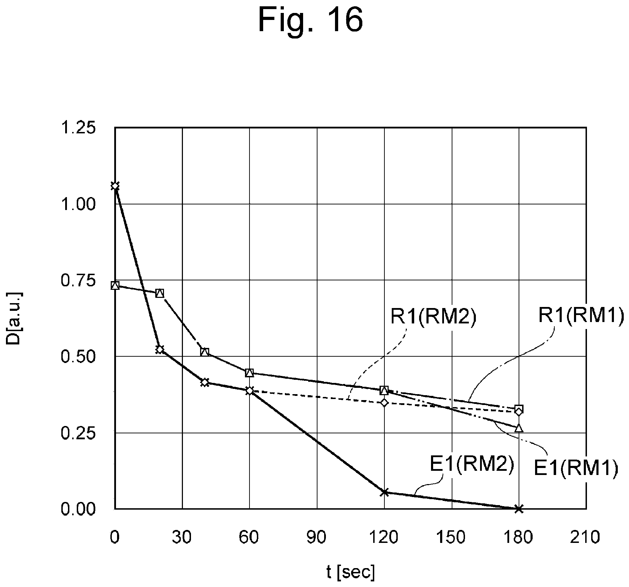

Figure 16 is a diagram illustrating results of development in Example 1 and Reference Example 1. In Figure 16, the horizontal axis "t [sec]" indicates the development time [seconds], and the vertical axis "D [a.u.]" indicates a standardized film thickness (ratio to a reference thickness) of the resist film RM. E1 (RM1) indicates a result of the first region RM1 of Example 1, and E1 (RM2) indicates a result of the second region RM2 of Example 1. R1 (RM1) indicates a result of the first region RM1 of Reference Example 1, and R1 (RM2) indicates a result of the second region RM2 of Reference Example 1.

As illustrated in Figure 16, in Example 1, the second region RM2 was selectively removed by the step ST120 (0 to 60 seconds), the purge step (60 seconds to 90 seconds), the step ST121 (90 seconds to 150 seconds), and the step ST120 (150 seconds to 180 seconds) of a second time. The decrease in the film thickness of the first region RM1 was limited, and the contrast of the development was also obtained. On the other hand, in Reference Example 1, the development speed of the second region RM2 decreased with the passage of the development time, the contrast of the development with the first region RM1 was not obtained, and thus the second region RM2 could not be selectively removed. In Example 1, it is considered that, by including the purge step and increasing the temperature of the substrate support 11 in the step ST121, the retention of the reaction product in the concave portion during the development is suppressed, and the development of the second region RM2 is promoted. In addition, in Example 1, in the step ST121, the processing gas did not include HBr gas and the pressure of the processing chamber 10 was maintained to be lower than that in the step ST120. Accordingly, it is considered that the influence of the increase in the development speed due to the increase in the temperature of the substrate support 11 is relaxed, and the removal of the first region RM1 is suppressed.

### <Configuration Example of Substrate Processing System>

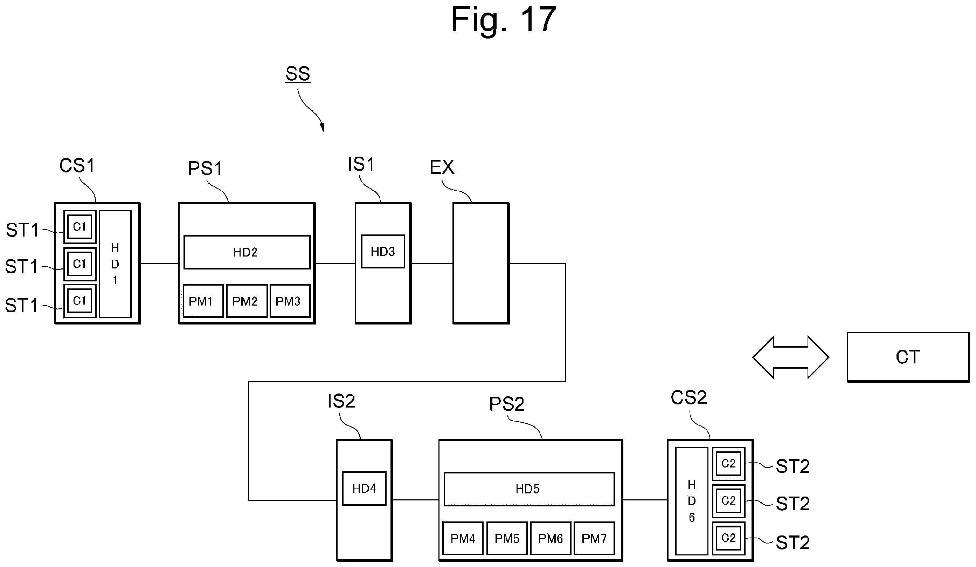

Figure 17 is a block diagram for describing a configuration example of a substrate processing system SS according to an exemplary embodiment. The substrate processing system SS includes a first carrier station CS1, a first processing station PS1, a first interface station IS1, an exposure apparatus EX, a second interface station IS2, a second processing station PS2, a second carrier station CS2, and a controller CT.

The first carrier station CS1 performs the carrying-in or carrying-out of the first carrier C1 between the first carrier station CS1 and an external system of the substrate processing system SS. The first carrier station CS1 has a stage including a plurality of first placing plates ST1. The first carrier C1 in a state where a plurality of substrates W is accommodated or in a state where the first carrier C1 is empty is placed on each first placing plate ST1. The first carrier C1 has a housing capable of accommodating the plurality of substrates W inside. In an example, the first carrier C1 is a front opening unified pod (FOUP).

In addition, the first carrier station CS1 transports the substrate W between the first carrier C1 and the first processing station PS1. The first carrier station CS1 further includes a first transport apparatus HD1. The first transport apparatus HD1 is provided at the first carrier station CS1 to be positioned between the stage and the first processing station PS1. The first transport apparatus HD1 transports and delivers the substrate W between the first carrier C1 on each first placing plate ST1 and the second transport apparatus HD2 of the first processing station PS1. The substrate processing system SS may further include a load lock module. The load lock module may be provided between the first carrier station CS1 and the first processing station PS1. The load lock module is able to switch the pressure inside thereof to atmospheric pressure or vacuum. The "atmospheric pressure" may be a pressure inside the first transport apparatus HD1. In addition, the "vacuum" is a pressure lower than the atmospheric pressure, and may be, for example, a medium vacuum of 0.1 Pa to 100 Pa. The inside of the second transport apparatus HD2 may be atmospheric pressure or vacuum. The load lock module may transport, for example, the substrate W from the first transport apparatus HD1, which is atmospheric pressure, to the second transport apparatus HD2, which is vacuum, and may transport the substrate W from the second transport apparatus HD2, which is vacuum, to the first transport apparatus HD1, which is atmospheric pressure.

The first processing station PS1 performs various types of processing on the substrate W. In an embodiment, the first processing station PS1 includes a preprocessing module PM1, a resist film forming module PM2, and a first heating processing module PM3 (hereinafter, also collectively referred to as a "first substrate processing module PMa"). In addition, the first processing station PS1 has a second transport apparatus HD2 that transports the substrate W. The second transport apparatus HD2 transports and delivers the substrate W between two designated first substrate processing modules PMa and between the first processing station PS1 and the first carrier station CS1 or the first interface station IS1.

In the preprocessing module PM1, the substrate W is subjected to the preprocessing. In an embodiment, the preprocessing module PM1 includes a temperature-controlled unit that adjusts the temperature of the substrate W, a high-precision temperature-controlled unit that adjusts the temperature of the substrate W with high precision, and the like. In an embodiment, the preprocessing module PM1 includes a surface reforming processor that performs surface reforming processing on the substrate W. Each processor of the preprocessing module PM1 may be configured to include the heating processing apparatus 100 (see Figure 1A), the plasma processing apparatus 1 (see Figures 2 and 3), and/or a liquid processing apparatus such as a spin coater.

In the resist film forming module PM2, the resist film is formed on the substrate W. In an embodiment, the resist film forming module PM2 includes a dry coating unit. The dry coating unit forms the resist film on the substrate W using a dry process such as a vapor deposition method. The dry coating unit includes, for example, a CVD apparatus or ALD apparatus that performs chemical vapor deposition on the resist film, or a PVD apparatus that performs physical vapor deposition on the resist film on the substrate W disposed in the chamber. The dry coating unit may be the heating processing apparatus 100 (see Figure 1) or the plasma processing apparatus 1 (see Figures 2 and 3).

In an embodiment, the resist film forming module PM2 includes a wet coating unit. The wet coating unit forms the resist film on the substrate W using a wet process such as a liquid phase deposition method. The wet coating unit may be, for example, the liquid processing apparatus such as the spin coater.

In an embodiment, the example of the resist film forming module PM2 includes both the wet coating unit and the dry coating unit.

In the first heating processing module PM3, the substrate W is subjected to the heating processing. In an embodiment, the first heating processing module PM3 includes one or more of a pre-baking (PAB) unit that performs the heating processing on the substrate W on which the resist film is formed, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1A). Each heating processing may be performed at a predetermined temperature using a predetermined gas.

The first interface station IS1 includes a third transport apparatus HD3. The third transport apparatus HD3 transports and delivers the substrate W between the first processing station PS1 and the exposure apparatus EX. The third transport apparatus HD3 may be configured to have a housing that accommodates the substrate W, and a temperature, humidity, pressure, and the like in the housing are controllable.

In the exposure apparatus EX, the resist film on the substrate W is exposed using an exposure mask (reticle). The exposure apparatus EX may be, for example, an EUV exposure apparatus having a light source that generates EUV light.

The second interface station IS2 includes a fourth transport apparatus HD4. The fourth transport apparatus HD4 transports or delivers the substrate W between the exposure apparatus EX and the second processing station PS2. The fourth transport apparatus HD4 may be configured to have a housing that accommodates the substrate W, and the temperature, humidity, pressure, and the like in the housing may be controllable.

The second processing station PS2 performs various types of processing on the substrate W. In an embodiment, the second processing station PS2 includes a second heating processing module PM4, a measurement module PM5, a developing module PM6, and a third heating processing module PM7 (hereinafter, also collectively referred to as a "second substrate processing module PMb"). In addition, the second processing station PS2 has a fifth transport apparatus HD5 that transports the substrate W. The fifth transport apparatus HD5 transports and delivers the substrate W between the two designated second substrate processing modules PMb and between the second processing station PS2 and the second carrier station CS2 or the second interface station IS2.

In the second heating processing module PM4, the substrate W is subjected to the heating processing. In an embodiment, the heating processing module PM4 includes any one or more of a post-exposure baking (PEB) unit that performs the heating processing on the substrate W after exposure, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1A). Each heating processing may be performed at a predetermined temperature using a predetermined gas.

In the measurement module PM5, various measurements are performed on the substrate W. In an embodiment, the measurement module PM5 includes an imaging unit including a stage on which the substrate W is placed, an imaging apparatus, an illumination apparatus, and various sensors (a temperature sensor, a reflectivity measuring sensor, and the like). The imaging apparatus may be, for example, a CCD camera that images the appearance of the substrate W. Alternatively, the imaging apparatus may be a hyperspectral camera that images light by spectrally separating the light for each wavelength. The hyperspectral camera may measure any one or more of a pattern shape, a dimension, a film thickness, a composition, and a film density of the resist film.

In the developing module PM6, the substrate W is subjected to development processing. In an embodiment, the developing module PM6 includes a dry development unit that performs dry development on the substrate W. The dry development unit may be, for example, the heating processing apparatus 100 (see Figure 1A) or the plasma processing apparatus 1 (see Figures 2 and 3).

In the third heating processing module PM7, the substrate W is subjected to the heating processing. In an embodiment, the third heating processing module PM7 includes any one or more of a post-bake (PB) unit that performs heating processing on the substrate W after development, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1A). Each heating processing may be performed at a predetermined temperature using a predetermined gas.

The second carrier station CS2 performs carrying-in and carrying-out of the second carrier C2 between the second carrier station CS2 and an external system of the substrate processing system SS. The configuration and the function of the second carrier station CS2 may be the same as those of the first carrier station CS1 described above.

The controller CT controls each configuration of the substrate processing system SS to execute given processing on the substrate W. The controller CT stores a recipe in which a process procedure, a process condition, a transport condition, and the like are set, and controls each configuration of the substrate processing system SS to execute given processing on the substrate W according to the recipe. The controller CT may serve as some or all of the functions of each controller (the controller 200 and the controller 2 illustrated in Figures 1A to 4, and the controller 400).

### <Example of Substrate Processing Method>

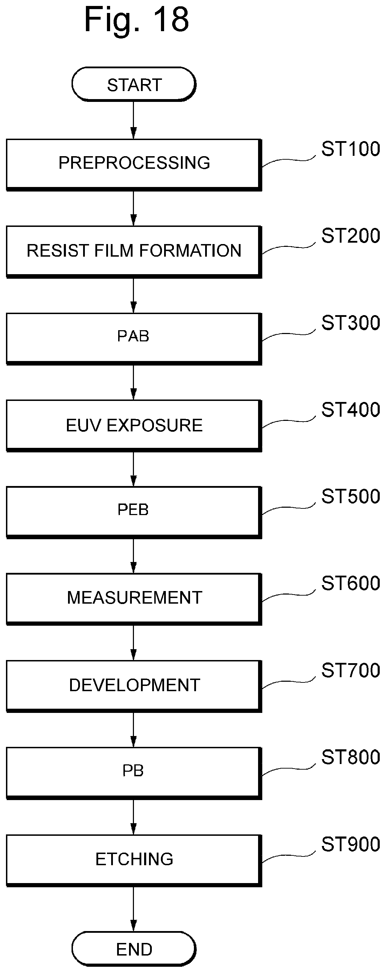

Figure 18 is a flowchart illustrating a substrate processing method (hereinafter, also referred to as a "method MT") according to an exemplary embodiment. As illustrated in Figure 18, the method MT includes a step ST100 of performing preprocessing on the substrate, a step ST200 of forming the resist film on the substrate, a step ST300 of performing heating processing (pre-baking: PAB) on the substrate on which the resist film is formed, a step ST400 of performing EUV exposure on the substrate, a step ST500 of performing heating processing (post-exposure baking: PEB) on the substrate after the exposure, a step ST600 of measuring the substrate, a step ST700 of developing the resist film of the substrate, a step ST800 of performing heating processing (post-baking: PB) on the substrate after the development, and a step ST900 of etching the substrate. The method MT may not include one or more of the above-described each step. For example, the method MT may not include the step ST600, and the step ST700 may be executed after the step ST500.

The method MT may be executed by using the substrate processing system SS illustrated in Figure 17. In the following, a case where the controller CT of the substrate processing system SS controls each unit of the substrate processing system SS to execute the method MT on the substrate W will be described as an example.

### (Step ST100: Preprocessing)

First, the first carrier C1 accommodating the plurality of substrates W is carried into the first carrier station CS1 of the substrate processing system SS. The first carrier C1 is placed on the first placing plate ST1. Next, each substrate W in the first carrier C1 is sequentially taken out by the first transport apparatus HD1 and delivered to the second transport apparatus HD2 of the first processing station PS1. The substrate W is transported to the preprocessing module PM1 by the second transport apparatus HD2. The preprocessing module PM1 performs the preprocessing on the substrate W. The preprocessing may include, for example, one or more of temperature adjustment of the substrate W, formation of a part or all of the underlying film of the substrate W, heating processing of the substrate W, and high-precision temperature adjustment of the substrate W. The preprocessing may include a surface reforming processing of the substrate W.

### (Step ST200: Resist Film Formation)

Next, the substrate W is transported to the resist film forming module PM2 by the second transport apparatus HD2. The resist film is formed on the substrate W by the resist film forming module PM2. In an embodiment, the resist film is formed by a wet process. For example, the resist film is formed by spin-coating the resist film on the substrate W using the wet coating unit of the resist film forming module PM2. In an embodiment, the resist film is formed on the substrate W by a dry process such as a vapor deposition method. For example, the resist film is formed by vapor-depositing the resist film on the substrate W using the dry coating unit of the resist film forming module PM2.

The resist film may be formed on the substrate W by using both the dry process and the wet process. For example, the second resist film may be formed on the first resist film by the wet process after the first resist film is formed on the substrate W by the dry process. In this case, the film thicknesses, materials, and/or compositions of the first resist film and the second resist film may be the same as or different from each other.

### (Step ST300: PAB)

Next, the substrate W is transported to the first heating processing module PM3 by the second transport apparatus HD2. The substrate W is subjected to the heating processing (pre-baking: PAB) by the first heating processing module PM3. The pre-baking may be performed in an air atmosphere or an inert atmosphere. In addition, the pre-baking may be performed by heating the substrate W to 50°C or higher or 80°C or higher. The heating temperature of the substrate W may be 250°C or lower, 200°C or lower, or 150°C or lower. In one example, the heating temperature of the substrate may be 50°C or higher and 250°C or lower. In a case where the resist film is formed by the dry process in the step ST200, in an embodiment, the pre-baking may be continuously executed by the dry coating unit that has executed the step ST200. In an embodiment, after the pre-baking, removing processing of the resist film at the end portion of the substrate W (edge bead removal: EBR) may be performed.

### (Step ST400: EUV Exposure)

Next, the substrate W is delivered to the third transport apparatus HD3 of the first interface station IS1 by the second transport apparatus HD2. Then, the substrate W is transported to the exposure apparatus EX by the third transport apparatus HD3. The substrate W is subjected to EUV exposure in the exposure apparatus EX through the exposure mask (reticle). As a result, on the substrate W, a first region where EUV exposure is performed and a second region where EUV exposure is not performed are formed corresponding to the pattern of the exposure mask (reticle).

### (Step ST500: PEB)

Next, the substrate W is delivered from the fourth transport apparatus HD4 of the second interface station IS2 to the fifth transport apparatus HD5 of the second processing station PS2. Then, the substrate W is transported to the second heating processing module PM4 by the fifth transport apparatus HD5. Then, the substrate W is subjected to the heating processing (post-exposure baking: PEB) in the second heating processing module PM4. The post-exposure baking may be performed in the air atmosphere. In addition, the post-exposure baking may be performed by heating the substrate W to 180°C or higher and 250°C or lower.

### (Step ST600: Measurement)

Next, the substrate W is transported to the measurement module PM5 by the fifth transport apparatus HD5. The measurement module PM5 measures the substrate W. The measurement may be an optical measurement or other measurements. In an embodiment, the measurement by the measurement module PM5 includes measurement of the appearance and/or dimensions of the substrate W using a CCD camera. In an embodiment, the measurement by the measurement module PM5 includes the measurement of any one or more of a pattern shape, a dimension, a film thickness, a composition, or a film density of a resist film using a hyperspectral camera (hereinafter, also referred to as "pattern shape and the like").

In an embodiment, the controller CT determines the presence or absence of the exposure abnormality of the substrate W based on the measured appearance, dimensions, and/or pattern shape, and the like of the substrate W. In an embodiment, in a case where the controller CT determines that there is an exposure abnormality, the substrate W may be reworked or discarded without performing the development in step ST700. The rework of the substrate W may be performed by removing the resist on the substrate W and returning to the step ST200 to form the resist film again. The rework after development may cause damage to the substrate W, but damage to the substrate W may be avoided or suppressed by performing the rework before development.

### (Step ST700: Development)

Next, the substrate W is transported to the developing module PM6 by the fifth transport apparatus HD5. In the developing module PM6, the resist film of the substrate W is developed. The development processing may be performed by dry development. The development processing in the step ST700 may be performed by the present processing method (see Figures 4 and 13). Desorption processing may be executed once or more after the development processing or during the development processing. The desorption processing includes removing (descumming) a scum from the surface of the resist film or smoothing the surface with an inert gas such as helium or plasma of the inert gas. In addition, in the developing module PM6, after the development processing, a part of the underlying film may be etched using the developed resist film as a mask.

### (Step ST800: PB)

Next, the substrate W is transported to the third heating processing module PM7 by the fifth transport apparatus HD5 and is subjected to the heating processing (post-baking). The post-baking may be performed in an air atmosphere or a reduced pressure atmosphere containing N₂ or O₂. In addition, the post-baking may be performed by heating the substrate W to 150°C or higher and 250°C or lower. The post-baking may be performed by the second heating processing module PM4 instead of the third heating processing module PM7. In an embodiment, the optical measurement of the substrate W may be performed by the measurement module PM5 after the post-baking. Such measurement may be executed in addition to the measurement in the step ST600 or instead of the measurement in the step ST600. In an embodiment, the controller CT determines the presence or absence of an abnormality or the like such as a defect, a scratch, or an adhesion of a foreign substance in the development pattern of the substrate W based on the measured appearance and dimensions of the substrate W and/or the pattern shape, and the like. In an embodiment, in a case where the controller CT determines that an abnormality has occurred, the substrate W may be reworked or discarded without performing the etching in step ST900. In an embodiment, in a case where the controller CT determines that an abnormality is present, the opening dimensions of the resist film of the substrate W may be adjusted by using the dry coating unit (CVD apparatus, ALD apparatus, or the like).

### (Step ST900: Etching)

After the execution of the step ST800, the substrate W is delivered to the sixth transport apparatus HD6 of the second carrier station CS2 by the fifth transport apparatus HD5, and is transported to the second carrier C2 of the second placing plate ST2 by the sixth transport apparatus HD6. Thereafter, the second carrier C2 is transported to a plasma processing system (not illustrated). The plasma processing system may be, for example, the plasma processing system illustrated in Figures 2 and 3. In the plasma processing system, the underlying film UF of the substrate W is etched using the resist film after development as a mask. As described above, the method MT ends. In a case where the resist film is developed using a plasma processing apparatus in step ST700, the etching may be continuously executed in the plasma processing chamber of the plasma processing apparatus. In addition, in a case where the second processing station PS2 includes a plasma processing module in addition to the developing module PM6, the etching may be executed in the plasma processing module. The above-described desorption processing may be executed once or more before or during the etching.

The embodiments of the present disclosure further include the following aspects.

### (Addendum 1)

A substrate processing method including:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove the second region from the metal-containing resist film,
in which the (b) includes
(b1) controlling a temperature of the substrate or the substrate support to a first temperature to perform development, and
(b2) controlling the temperature of the substrate or the substrate support to a second temperature different from the first temperature to perform development.

### (Addendum 2)

The substrate processing method according to Addendum 1, in which the second temperature is higher than the first temperature.

### (Addendum 3)

The substrate processing method according to Addendum 1 or 2, in which in the (b2), the processing gas is not supplied to the chamber, or a flow rate of the processing gas supplied to the chamber is smaller than a flow rate of the processing gas supplied to the chamber in the (b1).

### (Addendum 4)

The substrate processing method according to any one of Addendums 1 to 3, in which a pressure in the chamber in the (b2) is lower than a pressure in the chamber in the (b1).

### (Addendum 5)

The substrate processing method according to any one of Addendums 1 to 4, in which the (b) further includes purging the processing gas in the chamber between the (b1) and the (b2).

### (Addendum 6)

The substrate processing method according to any one of Addendums 1 to 5, in which in the (b1) and the (b2), the processing gas is supplied to the chamber at a constant flow rate.

### (Addendum 7)

A substrate processing method including:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove any one of the first region and the second region from the metal-containing resist film,
in which the (b) includes
(b1) performing development of the substrate under a first development condition, and
(b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

### (Addendum 8)

The substrate processing method according to Addendum 7, in which, in the (b), the development is performed using plasma formed from the processing gas, and the development parameter further includes a level of power of a source **RF** signal for forming the plasma supplied to the chamber and a level of power or a voltage of a bias signal supplied to the chamber.

### (Addendum 9)

The substrate processing method according to Addendum 8, in which the bias signal includes a bias **RF** signal or a voltage pulse, and
the development parameter further includes at least one of a frequency of the source **RF** signal, a frequency of the bias **RF** signal, and a frequency of the voltage pulse.

### (Addendum 10)

The substrate processing method according to Addendum 8 or 9, in which at least one of the source **RF** signal and the bias signal is pulsed, and the development parameter further includes at least one of a duty ratio of the pulsed source **RF** signal and a duty ratio of the pulsed bias signal.

### (Addendum 11)

The substrate processing method according to any one of Addendums 7 to 10, in which in the (b2), the second development condition is different from the first development condition in two or more of the development parameters.

### (Addendum 12)

The substrate processing method according to any one of Addendums 1 to 11, in which in the (b), the (b1) and the (b2) are repeated.

### (Addendum 13)

The substrate processing method according to any one of Addendums 1 to 11, in which in the (b), after a cycle including the (b1) and the (b2) is performed once or more, the (b1) is further performed.

### (Addendum 14)

The substrate processing method according to any one of Addendums 1 to 11, in which the (b) includes performing a cycle including the (b1) and the (b2) once or more by forming plasma from the processing gas after performing the cycle including the (b1) and the (b2) once or more without forming the plasma from the processing gas.

### (Addendum 15)

The substrate processing method according to any one of Addendums 1 to 11, in which the (b) includes performing a cycle including the (b1) and the (b2) once or more without forming plasma from the processing gas after performing the cycle including the (b1) and the (b2) once or more by forming the plasma from the processing gas.

### (Addendum 16)

The substrate processing method according to any one of Addendums 1 to 11, in which in at least one of the (b1) and the (b2), the first region or the second region is selectively removed using plasma formed from the processing gas.

### (Addendum 17)

The substrate processing method according to any one of Addendums 1 to 16, in which the metal-containing resist film includes at least one metal selected from the group consisting of Sn, Hf, and Ti.

### (Addendum 18)

The substrate processing method according to any one of Addendums 1 to 17, in which the processing gas includes a halogen-containing gas.

### (Addendum 19)

The substrate processing method according to any one of Addendums 1 to 18, in which an acidity of a processing gas used in the (b1) is different from an acidity of a processing gas used in the (b2).

### (Addendum 20)

The substrate processing method according to any one of Addendums 1 to 19, further including: (c) etching the underlying film using the metal-containing film after the development as a mask, after the (b).

### (Addendum 21)

The substrate processing method according to Addendum 20, in which the (c) is executed in a chamber different from the chamber used in the (b).

### (Addendum 22)

The substrate processing method according to Addendum 20, in which the (c) is executed in the chamber used in the (b).

### (Addendum 23)

The substrate processing method according to any one of Addendums 1 to 22, in which the first region is exposed to EUV.

### (Addendum 24)

The substrate processing method according to any one of Addendums 1 to 23, in which the temperature of the substrate or the substrate support is controlled by at least one selected from the group consisting of an output of a heater in the substrate support, an output of a heater in a side wall of the chamber accommodating the substrate support, an output of a heater in a ceiling of the chamber, a temperature of a heat transfer fluid flowing in the substrate support, a pressure of a heat transfer gas supplied between a back surface of the substrate and a front surface of the substrate support, and an output of electromagnetic waves configured to be emitted to a front surface of the substrate.

### (Addendum 25)

A substrate processing system comprising:
a substrate processing apparatus having a chamber; and
a controller,
wherein the controller is configured to cause, with respect to the substrate processing apparatus,
   (a) providing a substrate on a substrate support in the chamber, the substrate having an underlying film and a metal-containing resist film formed on the underlying film, the metal-containing resist film having an exposed first region and an unexposed second region, and
   (b) supplying a processing gas to the chamber to develop the substrate and to selectively remove the second region from the metal-containing resist film, and
   the (b) includes
   (b1) performing development by controlling a temperature of the substrate or the substrate support to a first temperature, and
   (b2) performing development by controlling the temperature of the substrate or the substrate support to a second temperature different from the first temperature.

### (Addendum 26)

A substrate processing system comprising:
a substrate processing apparatus having a chamber; and
a controller,
wherein the controller is configured to cause, with respect to the substrate processing apparatus,
   (a) providing a substrate on a substrate support in the chamber, the substrate having an underlying film and a metal-containing resist film formed on the underlying film, the metal-containing resist film having an exposed first region and an unexposed second region, and
   (b) supplying a processing gas to the chamber to develop the substrate and to selectively remove any one of the first region or the second region from the metal-containing resist film, and
   the (b) includes
   (b1) performing development of the substrate under a first development condition, and
   (b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

### (Addendum 27)

A device manufacturing method including:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove the second region from the metal-containing resist film,
in which the (b) includes
(b1) controlling a temperature of the substrate or the substrate support to a first temperature to perform development, and
(b2) controlling the temperature of the substrate or the substrate support to a second temperature different from the first temperature to perform development.

### (Addendum 28)

A device manufacturing method including:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove any one of the first region and the second region from the metal-containing resist film,
in which the (b) includes
(b1) performing development of the substrate under a first development condition, and
(b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

### (Addendum 29)

A program for causing a computer of a substrate processing system, which has one or a plurality of substrate processing apparatuses and a controller, to cause:
(a) providing a substrate on a substrate support in the chamber, the substrate having an underlying film and a metal-containing resist film formed on the underlying film, the metal-containing resist film having an exposed first region and an unexposed second region, and
(b) supplying a processing gas to the chamber to develop the substrate and to selectively remove the second region from the metal-containing resist film, and
the (b) includes
(b1) performing development by controlling a temperature of the substrate or the substrate support to a first temperature, and
(b2) performing development by controlling the temperature of the substrate or the substrate support to a second temperature different from the first temperature.

### (Addendum 30)

A program for causing a computer of a substrate processing system, which has one or a plurality of substrate processing apparatuses and a controller, to cause:
(a) providing a substrate on a substrate support in the chamber, the substrate having an underlying film and a metal-containing resist film formed on the underlying film, the metal-containing resist film having an exposed first region and an unexposed second region, and
(b) supplying a processing gas to the chamber to develop the substrate and to selectively remove any one of the first region or the second region from the metal-containing resist film, and
the (b) includes
(b1) performing development of the substrate under a first development condition, and
(b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

### (Addendum 31)

A storage medium storing the program according to Addendum 29 or 30.

Each of the above embodiments is described for the purpose of description, and is not intended to limit the scope of the present disclosure. Each of the above embodiments may be modified in various ways without departing from the scope and purpose of the present disclosure. For example, some configuration elements in one embodiment are able to be added to other embodiments. In addition, some configuration elements in one embodiment are able to be replaced with corresponding configuration elements in another embodiment.

### Reference Signs List

- 1: plasma processing apparatus
- 2: controller
- 10: plasma processing chamber
- 11: substrate support
- 20: gas supply
- 30: power supply
- 100: heating processing apparatus
- 102: processing chamber
- 120: stage heater
- 121: substrate support
- 141: gas nozzle
- 200: controller
- OP: opening
- RM: resist film
- RM1: first region
- RM2: second region
- UF: underlying film
- W: substrate

## Claims

1. A substrate processing method comprising:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove the second region from the metal-containing resist film,
wherein the (b) includes
(b1) controlling a temperature of the substrate or the substrate support to a first temperature to perform development, and
(b2) controlling the temperature of the substrate or the substrate support to a second temperature different from the first temperature to perform development.

2. The substrate processing method according to Claim 1, wherein the second temperature is higher than the first temperature.

3. The substrate processing method according to Claim 1 or 2, wherein in the (b2), the processing gas is not supplied to the chamber, or a flow rate of the processing gas supplied to the chamber is smaller than a flow rate of the processing gas supplied to the chamber in the (b1).

4. The substrate processing method according to Claim 1 or 2, wherein a pressure in the chamber in the (b2) is lower than a pressure in the chamber in the (b1).

5. The substrate processing method according to Claim 1 or 2, wherein the (b) further includes purging the processing gas in the chamber between the (b1) and the (b2).

6. The substrate processing method according to Claim 1 or 2, wherein in the (b1) and the (b2), the processing gas is supplied to the chamber at a constant flow rate.

7. A substrate processing method comprising:
(a) providing a substrate on a substrate support in a chamber, the substrate having an underlying film and a metal-containing resist film formed on the underlying film, the metal-containing resist film having an exposed first region and an unexposed second region; and
(b) supplying a processing gas to the chamber to develop the substrate and to selectively remove any one of the first region and the second region from the metal-containing resist film,
wherein the (b) includes
(b1) performing development of the substrate under a first development condition, and
(b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.

8. The substrate processing method according to Claim 7, wherein, in the (b), the development is performed using plasma formed from the processing gas, and the development parameter further includes a level of power of a source **RF** signal for forming the plasma supplied to the chamber and a level of power or a voltage of a bias signal supplied to the chamber.

9. The substrate processing method according to Claim 8, wherein the bias signal includes a bias **RF** signal or a voltage pulse, and
the development parameter further includes at least one of a frequency of the source **RF** signal, a frequency of the bias **RF** signal, and a frequency of the voltage pulse.

10. The substrate processing method according to Claim 8, wherein at least one of the source **RF** signal and the bias signal is pulsed, and the development parameter further includes at least one of a duty ratio of the pulsed source **RF** signal and a duty ratio of the pulsed bias signal.

11. The substrate processing method according to any one of Claims 7 to 10, wherein in the (b2), the second development condition is different from the first development condition in two or more of the development parameters.

12. The substrate processing method according to Claim 1 or 7, wherein in the (b), the (b1) and the (b2) are repeated.

13. The substrate processing method according to Claim 1 or 7, wherein in the (b), after a cycle including the (b1) and the (b2) is performed once or more, the (b1) is further performed.

14. The substrate processing method according to Claim 1 or 7, wherein the (b) includes performing a cycle including the (b1) and the (b2) once or more by forming plasma from the processing gas after performing the cycle including the (b1) and the (b2) once or more without forming the plasma from the processing gas.

15. The substrate processing method according to Claim 1 or 7, wherein the (b) includes performing a cycle including the (b1) and the (b2) once or more without forming plasma from the processing gas after performing the cycle including the (b1) and the (b2) once or more by forming the plasma from the processing gas.

16. The substrate processing method according to Claim 1 or 7, wherein in at least one of the (b1) and the (b2), the first region or the second region is selectively removed using plasma formed from the processing gas.

17. The substrate processing method according to Claim 1 or 7, wherein the metal-containing resist film includes at least one metal selected from the group consisting of Sn, Hf, and Ti.

18. The substrate processing method according to Claim 1 or 7, wherein the processing gas includes a halogen-containing gas.

19. The substrate processing method according to Claim 1 or 7, wherein an acidity of a processing gas used in the (b1) is different from an acidity of a processing gas used in the (b2).

20. The substrate processing method according to Claim 1 or 7, further comprising:
(c) etching the underlying film using the metal-containing film after the development as a mask, after the (b).

21. The substrate processing method according to Claim 20, wherein the (c) is executed in a chamber different from the chamber used in the (b).

22. The substrate processing method according to Claim 20, wherein the (c) is executed in the chamber used in the (b).

23. The substrate processing method according to Claim 1 or 7, wherein the first region is exposed to EUV.

24. The substrate processing method according to Claim 1 or 7, wherein the temperature of the substrate or the substrate support is controlled by at least one selected from the group consisting of an output of a heater in the substrate support, an output of a heater in a side wall of the chamber accommodating the substrate support, an output of a heater in a ceiling of the chamber, a temperature of a heat transfer fluid flowing in the substrate support, a pressure of a heat transfer gas supplied between a back surface of the substrate and a front surface of the substrate support, and an output of electromagnetic waves configured to be emitted to a front surface of the substrate.

25. A substrate processing system comprising:
a substrate processing apparatus having a chamber; and
a controller,
wherein the controller is configured to cause, with respect to the substrate processing apparatus,
(a) providing a substrate on a substrate support in the chamber, the substrate having an underlying film and a metal-containing resist film formed on the underlying film, the metal-containing resist film having an exposed first region and an unexposed second region, and
(b) supplying a processing gas to the chamber to develop the substrate and to selectively remove the second region from the metal-containing resist film, and
the (b) includes
(b1) performing development by controlling a temperature of the substrate or the substrate support to a first temperature, and
(b2) performing development by controlling the temperature of the substrate or the substrate support to a second temperature different from the first temperature.

26. A substrate processing system comprising:
a substrate processing apparatus having a chamber; and
a controller,
wherein the controller is configured to cause, with respect to the substrate processing apparatus,
(a) providing a substrate on a substrate support in the chamber, the substrate having an underlying film and a metal-containing resist film formed on the underlying film, the metal-containing resist film having an exposed first region and an unexposed second region, and
(b) supplying a processing gas to the chamber to develop the substrate and to selectively remove any one of the first region or the second region from the metal-containing resist film, and
the (b) includes
(b1) performing development of the substrate under a first development condition, and
(b2) performing development of the substrate under a second development condition different from the first development condition, the second development condition being different from the first development condition in at least one development parameter including a temperature of the substrate or the substrate support, a pressure in the chamber, a flow rate of the processing gas, a type of the processing gas, and a residence time of the processing gas on the substrate.
